# EUROPEAN PATENT APPLICATION

(11) **EP 4 819 586 A1**
(43) Date of publication of application: **07.10.2026**
(21) Application number: 24901071.1
(22) Date of filing: 04.12.2024
(51) Int. Cl.: H04L 67/12, H02J 50/40, H02J 50/20, A41D 1/00

(54) **NETWORK SYSTEM OF CONDUCTIVE FIBER AREA CAPABLE OF ROLE SWITCHING BETWEEN NETWORK DEVICES**

(30) Priority: 08.12.2023 KR 20230177401
(71) Applicant: Korea Electronics Technology Institute, Bundang-gu, Seongnam-si Gyeonggi-do 13509 (KR)
(72) Inventor: WON, Yun Jae, Seongnam-si Gyeonggi-do 13436 (KR)
(74) Representative: Isarpatent
(86) International application number: PCT/KR2024/019762
(87) International publication number: WO 2025/121885

(57) **Abstract**

The present invention relates to a conductive fabric area network system. The conductive fabric area network system according to the present invention comprises: one main conductive fabric area network device having a plurality of nodes; and one or more sub conductive fabric area network devices having a plurality of nodes. The network devices may each be included in different wearable devices from each other, and communicate among each other using at least any one communication means among wired communication and wireless communication.

## Description

### [Technical Field]

The present invention relates to a conductive fabric area network system.

### [Background Art]

The rapid evolution of wearable devices is one of the most exciting technology trends over the past decade. From initial wearable computers, such as a smartwatch, to soft suits that help people walk again, smart textiles have begun to appear as promising materials for manufacturing wearable devices, such as stretch sensors that may track movement and detect body posture or soft sensors for a wearable robot and virtual reality. Body area networks of wearable textiles still have challenges to overcome but also have the potential to change the way we live and work.

Wired communications, such as conductive yarns or printed conductive inks, have been used in body area networks since the late 2000s. However, wired communication faced challenges in terms of durability, data rates, and costs as the number of devices has increased. In addition, these issues may be addressed by integrating wireless communications into the wearable devices. Nevertheless, the wireless channels may be vulnerable to eavesdroppers and interference, and thus, require robust protocols, and each node requires its own battery to establish a wireless link between nodes, thereby adding weight to the fabric per device.

As the number of wearable devices is increasing and the demand for smart services has increased, it is important to develop protocols that simultaneously provide data and energy to reduce the number of cables and battery supplies around the body per device and enhance security. To manage and control a network with several nodes on conductive fabric, conductive fabric area network protocols should be created to exchange the necessary data and control commands.

In addition, the conductive fabric area network requires a robust system architecture and a flexible design that can adapt to new operating environments, standards, and markets.

### [Disclosure]

### [Technical Problem]

The present invention provides a conductive fabric area network system capable of transmitting and receiving data through a conductive fabric layer.

In addition, the present invention provides a conductive fabric area network system in which a mutually disconnected portion of clothing including a conductive fabric network wirelessly transmits power and data to perform charging and data storage management, collects various types of information, such as a physical condition of a clothing wearer, from a sensor connected to the conductive fabric network and stores the information, and allows the wearer to check information or confirm analysis results when necessary.

Aspects of the present disclosure are not limited to the above-mentioned aspects. That is, other aspects that are not mentioned may be obviously understood by those skilled in the art based on the following specification.

### [Technical Solution]

According to an embodiment of the present invention, a network system includes a main wired network device and a sub wired network device. The main wired network device and the sub wired network device communicate with each other using at least one of wired communication and wireless communication.

In an embodiment of the present invention, the main wired network device and the sub wired network device may be included in different wearable devices.

In an embodiment of the present invention, the main wired network device may further include a power supply device. In this case, the main wired network device may wirelessly transfer power to the sub wired network device.

In an embodiment of the present invention, the sub wired network device may further include a capacitor having an electrode using a conductive fabric layer. In this case, the sub wired network device may charge the capacitor with the power supplied from the main wired network device and transmit data to the main wired network device using the power charged in the capacitor.

In an embodiment of the present invention, the capacitor may use two separated conductive fabric layers as electrodes and include a dielectric layer interposed between the two conductive fabric layers.

In an embodiment of the present invention, the main wired network device may include a first master node and a repeater node, and the sub wired network device may include a second master node. The first master node may transmit and receive data to and from the repeater node through a conductive fabric layer, and the repeater node may wirelessly transmit and receive the data to and from the second master node.

In an embodiment of the present invention, the sub wired network device may further include a slave node that collects sensor data. In this case, the slave node may transmit the sensor data to the second master node, and the second master node may wirelessly transmit the sensor data to the repeater node.

In an embodiment of the present invention, the data transmitted and received between the repeater node and the second master node may include an identifier of the main wired network device, an identifier of the sub wired network device, an identifier of a node that transmits data, and an identifier of a node that receives data.

In an embodiment of the present invention, the main wired network device may further include a power supply device. In this case, the first master node may transfer power supplied from the power supply device to the repeater node through a conductive fabric layer, and the repeater node may wirelessly transfer the power to the second master node.

In an embodiment of the present invention, the main wired network device may further include the power supply device. The sub wired network device may further include a capacitor having an electrode using a conductive fabric layer. In this case, the first master node may transfer power supplied from the power supply device to the repeater node through the conductive fabric layer, and the second master node may charge the capacitor with the power supplied from the repeater node and transmit data generated by the sub wired network device to the repeater node using the power charged in the capacitor.

In an embodiment of the present invention, the capacitor may use two separated conductive fabric layers as electrodes and include a dielectric layer interposed between the two conductive fabric layers.

In an embodiment of the present invention, the repeater node may not transfer power to the second master node when the second master node transmits data to the repeater node.

In an embodiment of the present invention, any one or both of the main wired network device and the sub wired network device may be a device including a conductive fabric area network.

According to an embodiment of the present invention, a method of establishing a connection between wired network devices includes wirelessly transmitting, by a main wired network device, an association request message to a sub wired network device, transmitting, by the sub wired network device, an association response message to the main wired network device; and transmitting, by the main wired network device, an association acknowledgement message to the sub wired network device.

In an embodiment of the present invention, the association acknowledgement message may include an identifier of the main wired network device and a network identifier assigned to the sub wired network device by the main wired network device.

In an embodiment of the present invention, the transmitting of the association request message may include transmitting, by a first master node included in the main wired network device, the association request message to a second master node of the sub wired network device through a repeater node of the main wired network device, and transmitting, by the second master node, the association request message to a slave node of the sub wired network device.

In an embodiment of the present invention, the transmitting of the association response message may include transmitting, by the slave node, an association response message to the second master node, transmitting, by the second master node, the association response message to the repeater node, and transmitting, by the repeater node, the association response message to the first master node.

In an embodiment of the present invention, the transmitting of the association acknowledgement message may include transmitting, by the first master node, the association acknowledgement message to the second master node through the repeater node, and transmitting, by the second master node, the association acknowledgement message to the slave node. In this case, the association acknowledgement message may include a node identifier assigned to the slave node by the first master node.

According to an embodiment of the present invention, a conductive fabric area network system includes one main conductive fabric area network device having a plurality of nodes and one or more sub conductive fabric area network devices having a plurality of nodes. The network devices may be included in different garments or body mounts and communicate with each other using at least one communication of wired communication and wireless communication.

According to an embodiment of the present invention, a conductive fabric area network system includes a first wired network device equipped with a battery and a second wired network device equipped with a battery, in which the first wired network device and the second wired network device communicate with each other using at least one of wired communication and wireless communication, the first wired network device and the second wired network device include a power supply device, the first wired network device and the second wired network device determine one of the two devices to be the main wired network device and the other of the two devices to be the sub wired network device through mutual message exchange, and the main wired network device wirelessly transmits power to the sub wired network device.

According to an embodiment of the present invention, the network system includes the first wired network device and the second wired network device. The first wired network device includes a first master node and a first repeater node, and the second wired network device includes a second master node and a second repeater node. The first repeater node and the second repeater node communicate using a wireless communication method.

The first master node requests operation information for determining a main network from the second master node through the first repeater node and the second repeater node, and upon receiving the operation information from the second master node, determines one of the first wired network device and the second wired network device to be the main network device and the other of the first wired network device and the second wired network device to be a sub network device based on the operation information.

In an embodiment of the present invention, the operational information may be a state of charge of a battery installed in the second wired network device. In this case, the first master node determines the main network device based on the result of comparing the state of charge of the battery installed in the second wired network device with a state of charge of a battery installed in the first wired network device.

In an embodiment of the present invention, the operational information may be a startup time of the second wired network device. In this case, the first master node determines the main network device based on the result of comparing the startup time of the second wired network device with a startup time of the first wired network device.

In an embodiment of the present invention, the repeater node of the main network device may wirelessly transmit power to the repeater node of the sub network device.

In an embodiment of the present invention, the repeater node of the sub network device may transmit power to a master node of the sub network device under control of the master node of the sub network device.

In an embodiment of the present disclosure, the master node of the main network device may control the repeater node of the main network device so as not to transmit electrical power to the repeater node of the sub network device when data transmission is performed between the repeater node of the main network device and the repeater node of the sub network device.

In an embodiment of the present invention, the first wired network device may further include one or more first slave nodes. When the first slave node is added to a network inside the first wired network device, the first master node may apply a predetermined impedance matching technique to adjust an impedance of the first master node and the first slave node in real time.

In an embodiment of the present invention, the impedance matching technique may be any one of a complex conjugate matching technique, an equal impedance matching technique, and a voltage maximization matching technique, or a combination thereof.

In an embodiment of the present invention, the first wired network device and the second wired network device may be conductive fabric area network devices.

According to an embodiment of the present invention, a method of operating a network system includes a first wired network device including a first master node and a first repeater node, and a second wired network device including a second master node and a second repeater node, in which the first repeater node and the second repeater node communicate using a wireless communication method.

The operation method includes requesting, by the first master node, operation information for determining a main network from the second master node through the first repeater node and the second repeater node, receiving, by the first master node, operation information from the second master node, and determining, by the first master node, one of the first wired network device and the second wired network device to be a main network device and the other of the first wired network device and the second wired network device to be a sub network device based on the operation information.

In an embodiment of the present invention, the operational information may be a state of charge of a battery installed in the second wired network device. In this case, the determining of the main network device may include comparing, by the first master node, the state of charge of the battery installed in the second wired network device with a state of charge of a battery installed in the first wired network device and determining the main network device based on the comparison result.

In an embodiment of the present invention, the operational information may be a startup time of the second wired network device. In this case, the determining of the main network device may include comparing, by the first master node, the startup time of the second wired network device with a startup time of the first wired network device and determining the main network device based on the comparison result.

In an embodiment of the present invention, the operation method may further include wirelessly transmitting, by the repeater node of the main network device, power to the repeater node of the sub network device.

In an embodiment of the present invention, the operation method may further include transmitting, by the repeater node of the sub network device, power to the master node of the sub network device under control of the master node of the sub network device.

In an embodiment of the present invention, the operation method may further include determining, by the master node of the main network device, whether data transmission is performed between the repeater node of the main network device and the repeater node of the sub network device and controlling, by the master node of the main network, the repeater node of the main network device so as not to transmit power to the repeater node of the sub network device when the data transmission is performed between the repeater node of the main network device and the repeater node of the sub network device.

In an embodiment of the present invention, the first wired network device may further include one or more first slave nodes. In this case, the operation method may further include confirming, by the first master node, whether the first slave node is added to the network inside the first wired network device and applying, by the first master node, a predetermined impedance matching technique to adjust the impedance of the first master node and the first slave node in real time when the first slave node is added to the network inside the first wired network device.

In an embodiment of the present invention, the impedance matching technique may be any one of a complex conjugate matching technique, an equal impedance matching technique, and the voltage maximization matching technique, or a combination thereof.

In an embodiment of the present invention, the first wired network device and the second wired network device may be conductive fabric area network devices.

### [Advantageous Effects]

According to an embodiment of the present invention, it is possible to simply and efficiently control several nodes in a conductive fabric network.

In addition, according to an embodiment of the present invention, it is possible to provide services to multiple nodes and multiple conductive fabric area networks through an effective communication-based time strategy mechanism.

In addition, according to an embodiment of the present invention, by efficiently operating power by performing wireless power transmission between wearable devices according to a battery status of each of a plurality of wearable devices, it is possible to extend the usage time.

Effects which can be achieved by the present invention are not limited to the above-described effects. That is, other objects that are not described may be obviously understood by those skilled in the art to which the present invention pertains based on the following description.

### [Description of Drawings]

FIG. 1 is a superframe structure of a conductive fabric area network (CFAN).
FIG. 2 is a diagram illustrating a structure (physical elements) of the CFAN.
FIG. 3 is a state diagram of a conductive fabric area network master node (CFAN-M).
FIG. 4 is a state diagram of a conductive fabric area network slave node (CFAN-S).
FIG. 5 is a state diagram of a conductive fabric area network repeater node (CFAN-R).
FIG. 6 is a diagram illustrating a method of associating a CFAN.
FIG. 7 is a diagram illustrating a method of associating an extended CFAN.
FIG. 8 is a diagram illustrating a method of disassociating a CFAN.
FIG. 9 is a diagram illustrating a method of disassociating an extended CFAN.
FIG. 10 is a diagram illustrating an association status confirmation method of the CFAN.
FIG. 11 is a diagram illustrating an association status confirmation method of the extended CFAN.
FIG. 12 is a diagram illustrating a data transmission method of the CFAN during a response period.
FIG. 13 is a diagram illustrating a data transmission method of the extended CFAN during the response period.
FIG. 14 is a diagram illustrating a data transmission method of the CFAN during a spontaneous period.
FIG. 15 is a diagram illustrating a data transmission method of the extended CFAN during the spontaneous period.
FIG. 16 is a diagram illustrating a group ID set-up method.
FIG. 17 is a diagram illustrating a group ID set-up method of the extended CFAN.
FIG. 18 is a diagram illustrating a physical layer frame format.
FIG. 19 is a diagram illustrating a preamble format.
FIG. 20 is a diagram illustrating a header format.
FIG. 21 is a diagram illustrating an encoder of a header check sequence.
FIG. 22 is a diagram illustrating a payload format.
FIG. 23 is a diagram illustrating a definition of non-return-to-zero level (NRZ-L) coding.
FIG. 24 is a diagram illustrating amplitude-shift keying (ASK) modulation.
FIG. 25 is a diagram for Gaussian frequency shift keying (GFSK) modulation.
FIG. 26 is a diagram for a coding and modulation process of a preamble.
FIG. 27 is a diagram for a coding and modulation process of a header.
FIG. 28 is a diagram for a coding and modulation process of a payload.
FIG. 29 is a diagram for a GFSK modulation signal.
FIG. 30 is a diagram for an ASK modulation signal.
FIG. 31 is a planar e-textile design diagram.
FIG. 32 is a linear yarn design diagram.
FIG. 33 is a diagram illustrating an example of designing the CFAN using conductive materials arranged in parallel.
FIG. 34 is a block diagram illustrating a configuration of a network system according to a first embodiment of the present invention.
FIG. 35 is a block diagram illustrating a configuration of a network system according to a second embodiment of the present invention.
FIG. 36 is a flowchart for describing a method of operating the network system according to the second embodiment of the present invention.
FIG. 37 is a block diagram illustrating a computer system for implementing the method according to the embodiment of the present invention.

### [Best Mode]

Advantages and features of the present disclosure and methods to achieve them will be elucidated from embodiments described below in detail with reference to the accompanying drawings. However, the present disclosure is not limited to embodiments disclosed below and may be implemented in various different forms, these embodiments will be provided only in order to make the present disclosure complete and allow one of ordinary skill in the art to which the present disclosure pertains to completely recognize the scope of the present disclosure, and the present disclosure will be defined by the scope of the claims. Meanwhile, terms used in the present specification are for explaining exemplary embodiments rather than limiting the present disclosure. Unless explicitly described to the contrary, a singular form includes a plural form in the present specification. The terms "comprise" and/or "comprising" as used herein do not exclude the existence or addition of one or more other components, steps, operations, and/or elements in addition to the mentioned components, steps, operations, and/or elements.

Terms, such as "first" and "second," may be used to describe various components, but the interpretation of these components is not limited to these terms. These terms may be used to differentiate one component from other components. For example, the "first" component may be named the "second" component, and the "second" component may also be similarly named the "first" component without departing from the scope of the present invention.

It is to be understood that when one component is referred to as being "connected to" or "coupled to" another component, one component may be connected directly to or coupled directly to another component or be connected to or coupled to another component with still another component interposed therebetween. On the other hand, it is to be understood that when one component is referred to as being "connected directly to" or "coupled directly to" another component, it may be connected to or coupled to another component without still another component interposed therebetween. Other expressions describing a relationship between components, that is, "between," "directly between," "neighboring to," "neighboring directly to," and the like, are to be similarly interpreted.

When it is decided that a detailed description of a known art related to the present invention may unnecessarily obscure the gist of the present invention, the detailed description therefor will be omitted.

The following are definitions of key terms used in the present specification.

### Definition of Terms

### Wireless power transfer (WPT)

A method of transferring power between devices without wired connection using an electromagnetic field.

### Conductive fabric area network (CFAN)

A network that provides reliable communication using conductive fabric.

### CFAN-M

Master node of CFAN, a device node that manages and establishes an association between nodes in CFAN.

### CFAN-S

A slave node that constitutes the CFAN, a device node excluding the CFAN-M from CFAN.

### CFAN-R

A device node in the CFAN-S that enables WPT and serves to extend a range of the CFAN. It may be called a repeater node.

The following are abbreviations and their official names as used in this specification.

### Full name of abbreviations

ARA: Association Response Acknowledgement
ARQ: Association Request
ARS: Association Response
ASC: Association Status Confirmation
ASRA: Association Status Response Acknowledgement
ASRQ: Association Status Request
ASRS: Association Status Response
CFAN: Conductive Fabric Area Network
CFAN-M: Conductive Fabric Area Network Master node
CFAN-S: Conductive Fabric Area Network Slave node
CFAN-R: Conductive Fabric Area Network Repeater node
DA: Data Acknowledgement
DARA: Disassociation Response Acknowledgement
DARQ: Disassociation Request
DARS: Disassociation Response
DRA: Data Response Acknowledgement
DRQ: Data Request
DRRQ: Data Response Request
DRS: Data Response
FCS: Frame Check Sequence
GSRQ: Group ID Set-up Request
GSRS: Group ID Set-up Response
HCS: Header Check Sequence
LSB: Least Significant Bit
MAC: Media Access Control
NRZ-L: Non-Return-to-Zero Level
RA: Response Acknowledgement
RRQ: Response Request
RSRA: Repeater Set-up Response Acknowledgement
RSRQ: Repeater Set-up Request
RSRS: Repeater Set-up Response
TDMA: Time Division Multiple Access
UID: Unique Identifier
WPCN: Wireless Powered Communication Network
WPT: Wireless Power Transfer

### Scope

The present invention relates to a CFAN system. A protocol of a media access control layer and a physical layer of a conductive fabric network system for communication with a wearable sensor, an actuator, a processor, a battery, an e-textile, etc. are disclosed. The protocol establishes links and control for several devices on one or more CFANs for data and power transfer.

The media access control layer protocol is designed to perform the following tasks:
- configuring a simple network topology for communication
- forming a variable superframe structure for data transfer and flow control based on channels
- allocating resources between nodes for time and power sharing

The physical layer protocol is designed to perform the following tasks:
- modulation for low-cost implementation and reduced error performance
- setting a frequency suitable for the CFAN

### Outline

A CFAN system according to the present invention is a communication system capable of transmitting and receiving data through a conductive fabric-based network. The system operates one or more conductive fabric area networks (hereinafter, abbreviated as "CFAN"). The CFAN is designed by utilizing the characteristics of the conductive fabric. The system uses a carrier frequency to secure stable communication and a wide conductive fabric area even in a poor environment, a simple and robust modulation method such as amplitude shift keying (ASK) and frequency shift keying (FSK) to reduce implementation cost and error probability, and a coding technique for robustness against noise. In principle, a data rate of several thousand bits per second (kbps) is provided in the CFAN.

In addition, the system uses a simple and efficient network topology, such as a star or tree topology, for low power consumption. Dynamic address allocation is used for a packet size and efficient address management. The system uses a variable data rate and adaptive link quality control.

A device on a CFAN is classified into one of three nodes, such as a master node, a slave node, and a repeater node, depending on the role thereof. In the present invention, the master node may be expressed as CFAN-M, the slave node may be expressed as CFAN-S, and the repeater node may be expressed as CFAN-R. Basically, the CFAN is configured to include one CFAN-M, several CFAN-Ss, and a multipair CFAN-R.

The CFAN system according to the present invention may have one or more CFANs. In this case, there may be one main CFAN with a main CFAN-M and one or more sub CFANs, each of which has one sub CFAN-M.

When the slave node subscribes to the network (CFAN), the master node allocates a time slot to each device, i.e., the slave node, directly or through the CFAN-R based on a request of the slave node and a determination of the master node. The CFAN system according to the present invention uses a time division multiple access (TDMA) method for transmitting and receiving data.

A plurality of wearable devices having various shapes, locations, sizes, and weights may be installed in the CFAN. The device may be utilized in various applications, services, and industries, including the following examples:
- Health monitoring: detection, processing, and response according to a patient's condition or treatment
- Sports and fitness: recognition of body condition and improvement of activity capability
- Smart clothing: tracking and response with respect to body activity using industrial sensors or environmental sensors
- Military and soft suits: smart textiles capable of kinematic analysis and rapid situational response

The CFAN-S is systematically distributed throughout the conductive fabric area, and the CFAN-M is arranged at a center of the CFAN. The CFAN-R is located near an edge of the conductive fabric to interconnect the conductive fabric. When the CFAN-S receives sensing data from a sensor, the CFAN-S transmits the received data to the CFAN-M through the conductive fabric. The CFAN-M may transmit the data received by the CFAN-S to a monitoring center via other physical media such as wireless communication.

Hereinafter, embodiments of the present disclosure will be described in detail with reference to the accompanying drawings. The same means will be denoted by the same reference numerals throughout the accompanying drawings in order to facilitate a general understanding of the present invention in terms of describing the present invention.

### Network Components

### (1) General

Main components of the CFAN are divided into a time element and a physical element. The time element refers to a superframe composed of a request period, a response period, and a spontaneous period. The physical element refers to a network composed of the CFAN-M, the CFAN-R, and the CFAN-S. The CFAN-M manages the CFAN, the CFAN-R supports WPT and activates several CFANs, and the CFAN-S communicates with the CFAN-M.

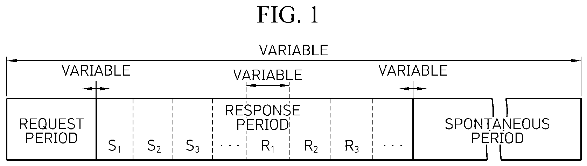

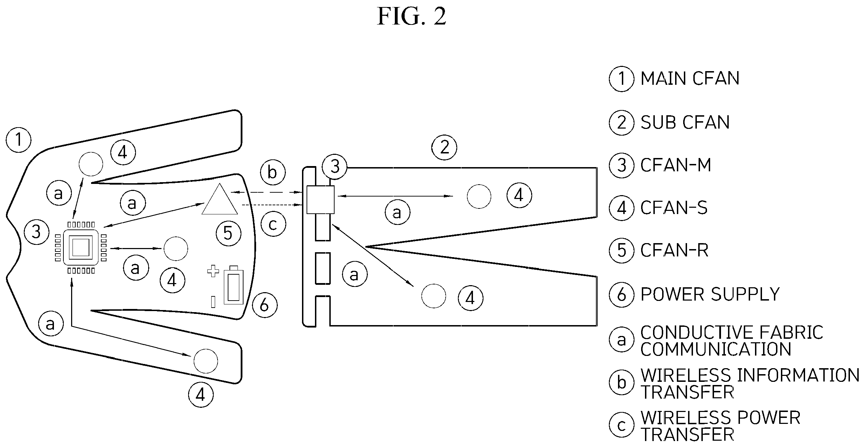

FIG. 1 illustrates the structure (time element) of the superframe, and FIG. 2 illustrates the structure (physical element) of the network. A node that should be first determined in the CFAN is the CFAN-M, and the superframe starts when the CFAN-M transmits a request packet during the request period. The CFAN-M manages association, disassociation, release, and scheduling of the CFAN-R and the CFAN-S.

Meanwhile, an extended CFAN is composed of a plurality of CFANs. The CFANs included in the extended CFAN are divided into a main CFAN, a sub CFAN, and an inter CFAN. The main CFAN is a CFAN that has a power supply and one or more CFAN-Rs, and the sub CFAN is a CFAN that needs to be supplied with energy from the main CFAN and does not have the CFAN-R. In addition, the inter CFAN constitutes a multipoint-to-point wireless powered communication network (WPCN) between the CFAN-R and the sub CFAN-M. The main CFAN-M manages the sub CFAN-M through the CFAN-R of the main CFAN.

### (2) Time Element

A time element used in the CFAN is a time slot of the TDMA method. The CFAN-M manages the CFAN-R and the CFAN-S that may transmit data, and time slots are assigned one-to-one to all nodes of a CFAN group selected by the CFAN-M. The superframe structure of the CFAN is composed of the request period, the response period, and the spontaneous period as illustrated in FIG. 1, and lengths of the periods are variable.

When several sub CFANs are associated with the main CFAN and thus the CFAN is extended, the superframe structure remains the same for all of the CFANs. The superframe starts via the CFAN-M, and the CFAN-M transmits a response request packet (RR packet) during the request period. The RR packet has information on an ID of the CFAN-R and an ID of the CFAN-S, and the CFAN-R and the CFAN-S transmit a response packet during the response period using the information in the RR packet.

In a case where there are the plurality of CFANs (extended CFANs), the CFAN-R is allocated a time slot such as other CFAN-Ss when acknowledged by the main CFAN-M. However, within the time slot, the CFAN-R needs to subdivide the time slot again to transmit data from the sub CFAN. In this case, the CFAN-R of the main CFAN associates with the CFAN-M and the CFAN-S of the sub CFAN which are not reachable by the main CFAN-M. The main CFAN and the sub CFAN may operate simultaneously.

During the request period of the main CFAN, the CFAN-M may transmit the RR packet to the CFAN-R and the CFAN-S so that the corresponding response packet is returned during the response period. In the sub CFAN, the CFAN-M should transmit the RR packet to the CFAN-S. In the inter CFAN (WPCN), the CFAN-R needs to transmit the RR packet to the associated sub CFAN-M.

In the response period of the main CFAN, the CFAN-R and the CFAN-S may transmit the response packet according to the RR packet of the CFAN-M received during the request period. The response period may be divided into several time slots according to the number of CFAN-Rs and the CFAN-Ss selected in the CFAN. The length of each time slot varies depending on a length of the response frame and an acknowledgement response. The CFAN-M reserves the time slot for the CFAN-R, the CFAN-S, or a specific group that uses the response period, and nodes of the allocated group independently transmit a data frame during the response period. A slot number is determined by the number of time slots, and otherwise the slot number is 0.

In the response period of the sub CFAN, the CFAN-S that joins the sub CFAN retransmits the response packet to its own CFAN-M based on the RR packet. The response period is divided into the time slots depending on the number of CFAN-Ss selected in the sub CFAN. A length of each time slot varies depending on length of the response packet and the acknowledged packet. The CFAN-Ss in the assigned group independently transmit a data frame during the response period.

During the response period of the inter CFAN (WPCN), the sub CFAN-M associated with the CFAN-R transmits a response back to the sub CFAN-M based on the RR packet. The response period is divided into the time slots depending on the number of CFAN-Ss selected in the sub CFAN. The length of each time slot varies depending on the length of the response packet and the acknowledged packet.

The spontaneous period of the CFAN starts when there is no device returning the response packet for a certain period of time. During the spontaneous period in the main CFAN, the CFAN-R and the CFAN-S may transmit data without a request from the CFAN-M. During the spontaneous period in the sub CFAN, the CFAN-S may transmit the data without the request from the CFAN-M. During the spontaneous period in the inter CFAN (WPCN), the sub CFAN-M may transmit data through the main CFAN without a request from the CFAN-R. The spontaneous period continues until the CFAN-M transmits the request period.

The superframe of the CFAN is divided into the request period, the response period, and the spontaneous period. The CFAN-M, the CFAN-R, and the CFAN-S of the CFAN operate as follows during each period.

[Request Period] In the request period of the main CFAN, the CFAN-M transmits the RR packet to the CFAN-R and the CFAN-S. Based on the RR packet, the CFAN-R or the CFAN-S that receives the RR packet determines whether to transmit the response packet during the response period. The CFAN-M may determine which CFAN-R and CFAN-S are selected from a group that will be transmitted during the response period. In the sub CFAN, the CFAN-M transmits the RR packet to the CFAN-S and determines whether to transmit the response packet during the response period after receiving the RR packet. The CFAN-M may determine which CFAN-Ss are grouped and transmitted during the response period.

[Response Period] The CFAN-R or the CFAN-S selected by the CFAN-M may transmit the response packet during the response period. When the CFAN-R or the CFAN-S transmits the response packet during the response period, the CFAN-M that receives the response packet transmits a response acknowledgement packet (RA packet). The CFAN-R or the CFAN-S that does not receive the RA packet transmits the response packet to every time slot until the CFAN-R or the CFAN-S receives the RA packet from the CFAN-M or a timeout occurs.

[Spontaneous Period] In the case of the main CFAN or the sub CFAN, when the CFAN-R or the CFAN-S does not transmit the response packet for a certain period of time, the spontaneous period starts, and this period is maintained until the CFAN-M transmits the RR packet. During the spontaneous period, the CFAN-R or the CFAN-S may transmit data without the request from the CFAN-M.

### (3) Physical Element

A physical element that constitutes the CFAN refers to devices that are divided into the CFAN-M, the CFAN-R, and the CFAN-S according to the role thereof. The CFAN is a network that may transmit and receive data between the CFAN-N, the CFAN-R, and the CFAN-S. The CFAN-M manages the entire CFAN, and in principle, there is only one CFAN-M per network. The CFAN-M broadcasts the RR packet to all nodes at once to control the CFAN-R and the CFAN-S. The CFAN-R and the CFAN-S need to transmit and receive the response packet under the control of the CFAN-M. When there are various CFANs, there should only be one main CFAN and several sub CFANs. The main CFAN may have one or more CFAN-Rs, but the sub CFANs do not have the CFAN-Rs. The CFAN may be configured as illustrated in FIG. 2.

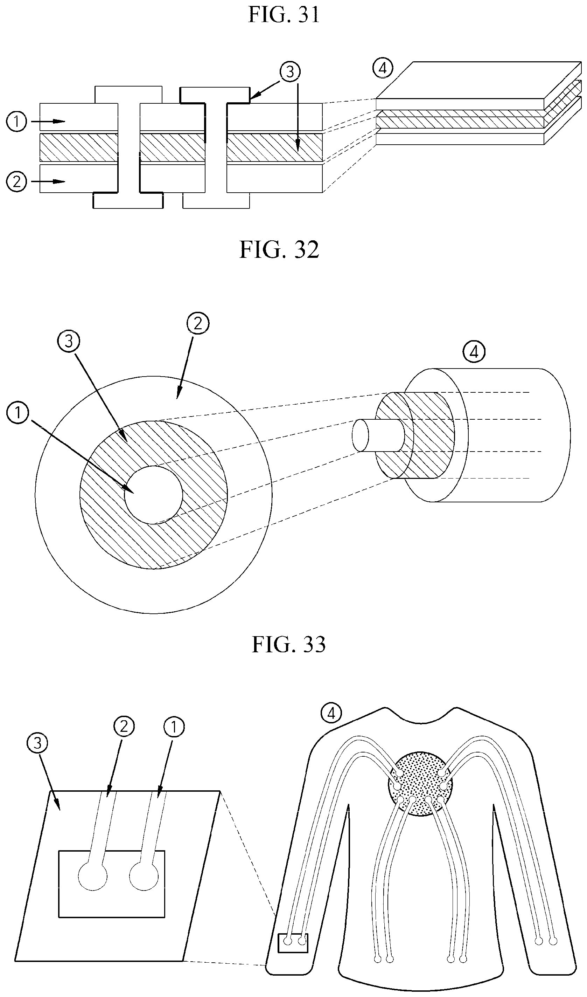

The main CFAN may have one or more power supplies, while the sub CFAN does not directly have a power supply. The power supply of the main CFAN may be a disposable battery using a pouch, while the power supply of the sub CFAN may be a flexible battery such as a lithium ion flexible battery or a lithium polymer flexible battery. In addition, as illustrated in FIG. 31, the flexible battery may be a secondary battery based on a conductive fabric layer in which a dielectric is interposed between conductive fabric layers that serve as electrodes forming a supercapacitor structure. The secondary battery may have a different charging amount, a different charging speed, and a different charging time depending on the material that constitutes the dielectric. As a method of charging a sub CFAN, the main CFAN may use an electromagnetic induction method or an optical charging method.

The CFAN-M (master node) is a node that manages the CFAN. In principle, only one CFAN-M exists in each network, and the CFAN-M manages and controls the CFAN-R and the CFAN-S using the RR packets. In a case where there are several CFANs, only one main CFAN-M may exist in the main CFAN, and only one sub CFAN-M may exist in each sub CFAN. The sub CFAN-M may communicate with the main CFAN-M through the CFAN-R associated with the sub CFAN-M. All the sub CFAN-Ms may collect energy and store the collected energy in the supercapacitor through the CFAN-R in the main CFAN. The sub CFAN-M uses energy to supply power to its own sub CFAN and transmit data to the CFAN-R.

The CFAN-S (slave node) is a node that constitutes the CFAN (excluding the CFAN-M and the CFAN-R), and there may be up to 65,519 CFAN-Ss per network. The response packet is transmitted according to the request packet transmitted by the CFAN-M in the network.

The CFAN-R (repeater node) is a node corresponding to the CFAN-S and is a device of the main CFAN that may transmit and receive data to and from the sub CFAN-M of the sub CFAN. The CFAN-R may transmit data to the sub CFAN-M while performing WPT. The sub CFAN-M may transmit data of all the CFAN-Ss to the CFAN-R at any given time, and the CFAN-R waits for its corresponding time slot during the response period of the main CFAN in order to transmit data. The CFAN-R enables association between the main CFAN and several sub CFANs.

### (4) Address Element

The CFAN uses a CFAN ID, a UID, a group address, a node address, and other address systems to identify each of the CFAN-R and CFAN-S.

The CFAN ID is a unique ID that identifies each CFAN from other CFANs. This value is not repeated in other CFANs and remains as long as the CFAN continues to exist. The CFAN ID is an 8-bit address ID assigned by the CFAN-M. The CFAN ID is assigned to a source CFAN ID and a destination CFAN ID. The CFAN ID for broadcasting to all of the CFANs may be designated as shown in Table 1 (Designated CFAN ID).

**[Table 1]**

| **CFAN ID** | **Content** | **Remarks** |
|---|---|---|
| OxFF | AU CFANs | When broadcasting to all CFANs |
| OxFO-OxFE | Reserved | - |

The UID is a unique identifier composed of 64 bits. The UID may be composed of a group address, an integrated circuit (IC) manufacturer code, and an IC manufacturer serial number as shown in Table 2 (UID Structure). The CFAN-S is identified by the UID.

**[Table 2]**

| **1 byte** | **1 byte** | **6 bytes** |
|---|---|---|
| Group ID | IC manufacturer's code | IC manufacturer's serial number |

A group ID is an identifier of the CFAN-R and CFAN-S groups classified in the CFAN. The CFAN-M may request data transmission in group units during the request period. The group units are used based on applications. Some group IDs may be designated as shown in Table 3 (Designated Group ID).

**[Table 3]**

| **Group ID** | **Content** | **Remarks** |
|---|---|---|
| OxFF | All groups | When selecting all groups |
| OxFO - OxFE | Reserved | - |

A node ID is an 8-bit address assigned by the CFAN-M as an identifier used instead of the UID to identify each node. The node ID may be assigned to a source address and a destination address. Some node IDs may be designated as shown in Table 4 (Designated Group ID).

**[Table 4]**

| **Node ID** | **Content** | **Remarks** |
|---|---|---|
| OxFF | All nodes | When broadcasting or transmitting to all nodes |
| OxFE | Unjoined CFAN-S | Default ID for CFAN-S |
| OxFD | Unjoined CFAN-R | Default ID for CFAN-R |
| OxFO - OxFC | Reserved | - |

### Network Status

### (1) General

In the CFAN, the CFAN-R and the CFAN-S obtain an active state of network configuration, network association, network disassociation, network association confirmation, data transmission, and network release.

### (2) Network Configuration

The CFAN-M forms a network by transmitting the request packet to the CFAN-R and the CFAN-S during the request period. The CFAN ID is included in the request packet so that the CFAN-R or the CFAN-S may identify the associated network. When the CFAN-R or the CFAN-S returns the response packet to the CFAN-M, the main network is formed. A minimum network period means the case where there is only the CFAN-M and is composed only of the request period and the spontaneous period.

In the extended CFAN, the CFAN-R forms a network by transmitting the request packet containing the CFAN ID to the sub CFAN-M. The extended network is configured when the sub CFAN-M returns the response packet to the CFAN-R.

### (3) Network Association

When the CFAN-M broadcasts an association request packet, the CFAN-R and the CFAN-S transfer the association request packet received during the response period. Upon reception, the CFAN-R and the CFAN-S search for the received packet and are associated with the network based on the found packet. When the CFAN-R and the CFAN-S find a correct network, the CFAN-R and the CFAN-S transmit the association response packet to the CFAN-M. The CFAN-M transmits a final acknowledgment to the CFAN-R and the CFAN-S, and when the CFAN-R and the CFAN-S receive the final acknowledgment, the network association is completed in the main CFAN. In the extended CFAN, the CFAN-M transmits the association request packet to all the CFAN-Rs, and accordingly the CFAN-Rs transmit the association request packet to the sub CFAN-M. The sub CFAN-M responds with respect to the received association request packet to the CFAN-R, and the CFAN-R transmits this response packet to the main CFAN-M. Then, the main CFAN-M transmits an acknowledgement to the sub CFAN-M through the CFAN-R. Finally, the CFAN-M transmits the association request packet to the CFAN-S belonging to the sub CFAN through the CFAN-R and the sub CFAN-M. Subsequently, the CFAN-S responds to the main CFAN-M with the association response packet, and the main CFAN-M transmits the association response confirmation packet. After the CFAN-S of the sub CFAN receives the acknowledgement, the extended network association is completed.

### (4) Network Disassociation

The CFAN-S, the CFAN-R, or the sub CFAN-M associated with the CFAN may follow the request of the CFAN-M or may be automatically disassociated. In the extended CFAN, a node association of the sub CFAN is performed by the CFAN-R and the sub CFAN-M to reach the CFAN-S of the sub CFAN. The main CFAN-M may transmit a disassociation request to the CFAN-S, the CFAN-R, or the sub CFAN-M according to a current network status or a service type for forced disassociation. In the case of voluntary disassociation, the main CFAN-M may recognize the disassociation status of the CFAN-S, the CFAN-R, or sub CFAN-M through the response result of the next association request packet.

### (5) Network Association Check

The association status of the CFAN-S, the CFAN-R, or the sub CFAN-M in the network may be requested by the main CFAN-M. To check the network association status, the main CFAN-M transmits an association status request packet to the CFAN-S, the CFAN-R, or the sub CFAN-M. The CFAN-S, the CFAN-R, or the sub CFAN-M returns an association status response packet to the main CFAN-M. When the acknowledgement packet is transmitted from the main CFAN-M to the CFAN-S, the CFAN-R, or the sub CFAN-M during the same process, the network association check is completed. When the main CFAN-M transmits and receives an association status packet to and from the CFAN-S of the sub CFAN in the extended CFAN, the packet passes through the CFAN-R and the sub CFAN-M.

### (6) Data Transmission

When the main CFAN-M transmits a data RR packet within the request period, the CFAN-S, the CFAN-R, or the sub CFAN-M responds with respect to a data response packet to the main CFAN-M according to a type of requested data. The main CFAN-M that receives the data response packet transmits a data acknowledgment packet, and the data transmission is completed after the CFAN-S, the CFAN-R, or the sub CFAN-M receives the data acknowledgment packet. In the extended CFAN, the main CFAN-M and the CFAN-S of the sub CFAN exchange the data acknowledgment packet through the CFAN-R and the sub CFAN-M.

### (7) Network Release

The CFAN release may be divided into normal release according to the request of the main CFAN-M and abnormal release due to a sudden condition. The normal release is achieved through the process in which the main CFAN-M determines the release status and distributes the request to all of the CFAN-Ss, the CFAN-R, and the sub CFAN-M to cancel the network. The abnormal network release refers to the case in which all the participating CFAN-S, CFAN-R, and sub CFAN-M are terminated at the same time.

### (8) Network Node State (CFAN node state)

A CFAN node state includes the CFAN-M state, the CFAN-S state, and the CFAN-R state. When the main CFAN is turned on, the main CFAN-M switches to the request period. When there is no response, the CFAN-M remains in the request period. When the CFAN-M receives the response acknowledgement packet, the state changes to the response period. When the CFAN-R is turned on in the main CFAN, the CFAN-R may turn on sub CFAN-Ms nearby through the WPT.

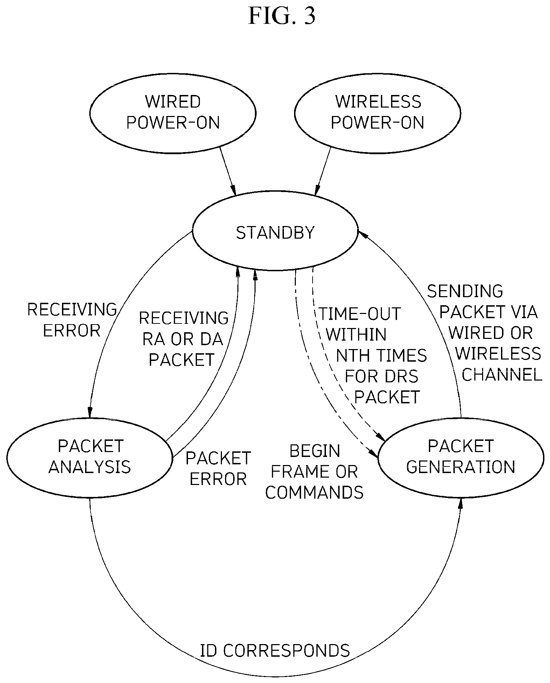

FIG. 3 is a state diagram of the CFAN-M.

The state of the CFAN-M is in a standby state when a power supply is turned on by wired power of the conductive fabric. When the CFAN-M is in the sub CFAN of the extended CFAN, the CFAN-M is in the standby state when the power supply is turned on by the WPT. In the standby state, when a superframe starts or an application program transmits a command, the state of the CFAN-M is in a packet generation state. The CFAN-M generates an RR packet and transmits the generated RR packet to the CFAN-R and the CFAN-S, and the state of the CFAN-M returns to the standby state.

When the CFAN-M receives a packet from the CFAN-R or the CFAN-S in the standby state, the state of the CFAN-M is in a packet analysis state. When a source ID and a destination ID of the received packet belong to a current CFAN, the state of the CFAN-M is in the packet generation state. Then, the CFAN-M generates an RA or DA packet and transmits the generated RA or DA packet to the CFAN-R or the CFAN-S of the corresponding medium. Thereafter, the state of the CFAN-M returns to the standby state.

On the other hand, when the CFAN-M receives the RA or DA packet in the packet analysis state or there is mismatch or error in the data packet, the state of the CFAN-M immediately returns to the standby state. When there is timeout, mismatch, or error in the acknowledgement packet received in the standby state, the CFAN-M regenerates a packet in the packet generation state and retransmits the regenerated packet to the CFAN-R and the CFAN-S through a medium, and then the state of the CFAN-M returns to the standby state. When these failures occur consecutively, the packet retransmission procedure is repeated as many times as necessary (up to N times). During the (N+1) procedure, the state of the CFAN-M remains in the standby state.

In the extended CFAN, when the CFAN-R is near the sub CFAN-M, the sub CFAN-M may receive wireless power from the CFAN-R and be used to supply the received wireless power to the sub CFAN. When the main CFAN-M transmits a packet to the sub CFAN, the CFAN-R transmits the packet to the sub CFAN-M via a wireless channel, and the sub CFAN-M switches from the standby state to the packet analysis state. When a destination CFAN ID corresponds to the sub CFAN ID, the sub CFAN-M switches to the packet generation state and transmits the packet to the corresponding CFAN-S or the CFAN-S. Then, the sub CFAN-M returns to the standby state. When the sub CFAN transmits a packet to the main CFAN, the sub CFAN-M switches from the standby state to the packet analysis state and receives the packet from the CFAN-S. When the destination CFAN ID corresponds to the main CFAN ID, the sub CFAN-M switches to the packet generation state and transmits the packet to the CFAN-R via the wireless channel during the corresponding period. Subsequently, the sub CFAN-M returns to the standby state.

The CFAN-S returns to the standby state as soon as it starts operating. When the application program transmits system data in the standby state, the state of the CFAN-S is in the packet generation state. The CFAN-S generates a packet during the spontaneous period and transmits the generated packet to the CFAN-M. Then, the state of the CFAN-S returns to the standby state.

When the CFAN-S receives a packet in the standby state, the CFAN-S returns to the packet analysis state, and the CFAN-S analyzes the received packet. When the received packet is the RR packet and the destination ID matches, the state of the CFAN-S is in the packet generation state, and the CFAN-S transmits the response packet to the CFAN-M. Then, the state of the CFAN-S returns to the standby state.

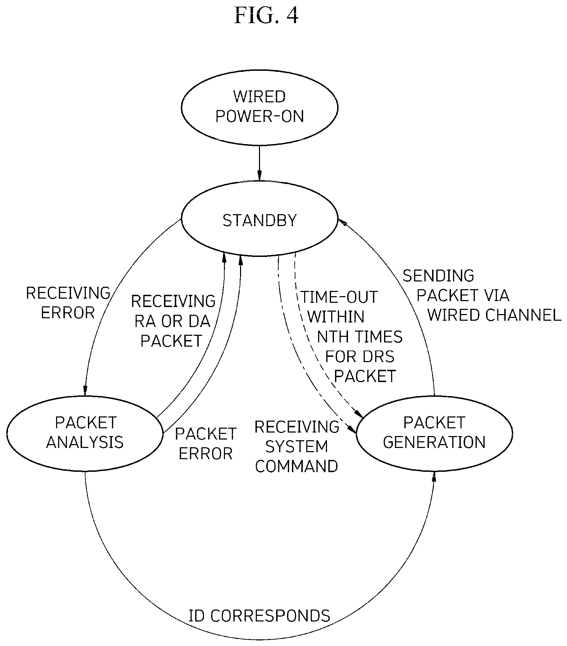

FIG. 4 is a state diagram of the CFAN-S. When the received packet of the packet analysis of the CFAN-S is an error packet or the RA or DA packet, the CFAN-S is in the standby state. When the CFAN-S does not receive the RA or DA packet during the timeout period, the state of the CFAN-S changes from the standby state to the packet generation state. Then, the CFAN-S regenerates the response packet and retransmits the regenerated response packet to the CFAN-M, and the state of the CFAN-S switches from the packet generation state to the standby state. The retransmission of the response packet is repeated as many times as necessary (up to N times). During a (N+1)^{th} timeout period, the CFAN-S remains in the standby state.

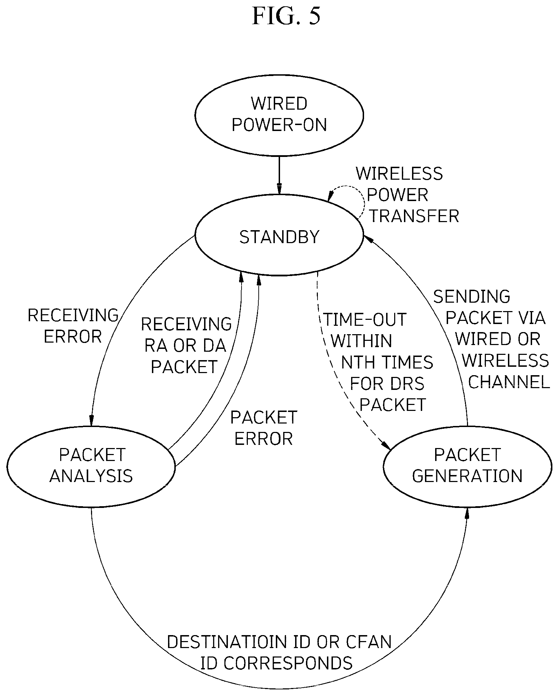

FIG. 5 is a state diagram of the CFAN-R.

The state of the CFAN-R is in the standby state when the power supply is turned on. When the CFAN-R receives a packet in the standby state, the CFAN-R is in the packet analysis state and analyzes the received packet. When the received packet is the RR packet and the destination ID matches, the state of the CFAN-R is in the packet generation state and transmits the response packet through an appropriate medium. Then, the state of the CFAN-R switches to the standby state.

When the received packet in the packet analysis state is a packet error or the RA or DA packet, the CFAN-R is in the standby state. When the CFAN-R does not receive the RA packet or the DA packet during the timeout period, the CFAN-R switches from the standby state to the packet generation state. Then the CFAN-R regenerates the response packet and retransmits the regenerated response packet to the CFAN-M, and the state of the CFAN-R is in the standby state. The retransmission of the response packet is repeated as many times as necessary (up to N times). During the (N+1)^{th} timeout period, the CFAN-S remains in the standby state.

In the extended CFAN, when the sub CFAN-M is near the CFAN-R, the CFAN-R may supply power to the sub CFAN through the WPT in the standby state. When the main CFAN-M transmits a packet to the sub CFAN, the CFAN-R switches from the standby state to the packet analysis state. When the destination CFAN ID corresponds to the sub CFAN ID, the CFAN-R switches to the packet generation state and transmits a packet to the sub CFAN-M via the wireless channel. Then, the CFAN-R returns to the standby state. When the sub CFAN-M transmits a packet to the main CFAN via the wireless channel, the CFAN-R switches from the standby state to the packet analysis state to receive the packet. When the destination CFAN ID corresponds to the main CFAN ID, the CFAN-R switches to the packet generation state and transmits a packet to the main CFAN-M via the wired channel during the corresponding period. Then, the CFAN-R returns to the standby state.

### MAC Layer Frame Format

### (1) General

A medium access control (MAC) frame format of the CFAN is composed of a frame header and a frame body. The frame header has information about data regarding the association between the CFAN-R and the CFAN-S, and the frame body has data for transmission between CFAN nodes.

### (2) Frame Format

All frame formats of the MAC are composed of the frame header and the frame body as shown in Table 5.

**[Table 5]**

| **2 bytes** | **1 byte** | **1 byte** | **1 byte** | **1 byte** | **1 byte** | **Variable** | **2 bytes** |
|---|---|---|---|---|---|---|---|
| Frame control | Source CFAN ID | Source address | Destination CFAN ID | Destination address | Sequence number | Payload | Frame check sequence |
| Frame header | | | | | | Frame body | |

The frame header is composed of a frame control, a source CFAN ID, a source address, a destination CFAN ID, a destination address, and a sequence number. The frame header has information for frame transmission/reception and flow control. The frame header may be used for the data transmission.

A frame control field is composed of a frame type, an acknowledgement policy, a first fragment, a last fragment, and a protocol version as shown in Table 6. A unit in row 1 of Table 6 is a bit.

**[Table 6]**

| **0-2** | **3-4** | **5** | **6** | **7-8** | **9-15** |
|---|---|---|---|---|---|
| Frame type | Acknowledgement policy | First fragment | Last fragment | Protocol version | Reserved |

The description in each field included in the frame control field is as follows:
1) The frame type field is composed of 3 bits. The frame type field will be described below in detail.
2) The acknowledgment policy field is composed of 2 bits. When the received frame is an acknowledgment frame, the received frame indicates a policy of the received acknowledgment frame, and otherwise, the received frame indicates a policy of an acknowledgment frame for a destination node. Each item of the acknowledgment policy will be described below in detail.
   a) No acknowledgment: The destination node does not acknowledge the transmitted frame, and the source node considers the transmission to be successful regardless of the transmission result. This method may be used in a frame transmitted for 1:1 or 1:N transmission that does not require ACK.
   b) Single acknowledgment: A destination node that receives the frame transmits the acknowledgment frame as a response to the source node after a short interframe space (SIFS). This acknowledgment policy may only be used for 1:1 transmission.
   c) Multiple acknowledgment: A destination node that receives the frame transmits the acknowledgment frame as a response to multiple source nodes after a SIFS. This acknowledgment policy may be used for 1:N transmission.
   d) Data acknowledgment: A destination node that receives a data frame transmits a data acknowledgment frame as a response to the source node after a SIFS. This acknowledgment policy may only be used for 1:1 data transmission.
3) The first fragment field is composed of 1 bit. "1" indicates that the frame refers to a start of a request, response, or data packet of a higher level, and "0" indicates that the frame does not refer to the start.
4) The last fragment field is composed of 1 bit. "1" indicates that the frame refers to an end of the request, response, or data packet of a higher level, and "0" indicates that the frame does not refer to the end.
5) A protocol version field is composed of 2 bits and its size and position are fixed regardless of a protocol version of the system. A current value is 0 and increases by 1 whenever a new version is released. When the node receives a packet with a higher version than its own, the node is discarded without notifying the source node.
6) Reserved: This field is prepared for future use.

A CFAN ID field is composed of 1 byte each and is used to identify the network as shown in Table 5. In the frame, the source CFAN ID indicates the CFAN where a transmitting node is located, and the destination CFAN ID indicates the CFAN where a receiving node is located.

The node ID is used to identify nodes within each network. The source node ID and the destination ID are each composed of 1 byte.

A sequence number field length is 8 bits and indicates a frame sequence number. In the data frame, a sequence number between 0 and 255 is assigned through an incremental counter for each packet and is reset to 0 again when the sequence number reaches 255.

The frame body is composed of a payload including data for transmission between the CFAN nodes and a frame check sequence (FCS) for checking errors in the payload. Each payload has a different format depending on the frame type of the frame control field.

The payload has data to be transmitted between the main CFAN-M and each of the CFAN-S, CFAN-R, and sub CFAN-M, and a length of the payload is a variable value between 0 and 247.

The frame check sequence (FCS) is 16 bits long and is used to confirm whether the frame body has been received without errors. The FCS is generated using a 16-order standard generator polynomial as provided in Equation 1. [Equation 1] $G \left(x\right) = {x}^{16} + {x}^{12} + {x}^{5} + 1$

### (3) Frame Type

The frame types are defined as a total of four types: a request frame, a response frame, a data frame, and an acknowledgement frame. Table 7 illustrates frame types and a binary value, content, and time element (period) for each frame type.

**[Table 7]**

| **The frame type** | **Value (Binary)** | **Content** | **Period** |
|---|---|---|---|
| Request frame | 000 | Request for the response of association, disassociation, association status, data trans mission, etc. | Request |
| Response frame | 001 | Response for the request of association, disassociation, association status, data trans mission, etc. | Response |
| Data frame | 010 | Data transmission without a request | Spontaneous |
| Acknowledgement frame | 011 | Acknowledgement of the response and data transmission | Response, Spontaneous |

The request frame is used when the main CFAN-M transmits the request packet to a specific CFAN-S, CFAN-R, or sub CFAN-M of the CFAN during the request period or broadcasts information to all of the CFAN-S, CFAN-R, and sub-CFAN-M. In the extended CFAN, the request frame is used when the CFAN-R transmits the request packet to the sub CFAN-M during the request period. The request frame may be configured as shown in Table 8. A unit in row 1 of Table 8 is a byte.

**[Table 8]**

| **8** | **1** | **1** | **1** | **LI** | **L2** | **...** | **Ln** | **2** |
|---|---|---|---|---|---|---|---|---|
| Frame Header | Group ID | Request code | Length (=∑ Ln) | Request block-1 | Request block-2 | ... | Request block-n | Frame check sequence |
| | Request frame payload | | | | | | | |
| | Frame body | | | | | | | |

The response frame is used when the CFAN-S, the CFAN-R, or the sub CFAN-M transmits the response packet during the request period for the request from the main CFAN-M. The appropriate CFAN-S, CFAN-R, or sub CFAN-M transmits the response packet during the request period within the designated number of times until the CFAN-S, CFAN-R, or sub CFAN-M receives an acknowledgment packet. In the extended CFAN, the sub CFAN-M transmits the response packet during the request period for the CFAN-R request. The response frame may be configured as shown in Table 9. A unit in row 1 of Table 9 is a byte.

**[Table 9]**

| **8** | **1** | **1** | **1** | **LI** | **L2** | **...** | **Ln** | **2** |
|---|---|---|---|---|---|---|---|---|
| Frame header | Group ID | Response code | Length (=Σ Ln) | Response block -1 | Response block-2 | ... | Response block- n | Frame check sequence |
| | Response frame payload | | | | | | | |
| | Frame body | | | | | | | |

The data frame is used when the CFAN-S, the CFAN-R, or the sub CFAN-M transmits data to the main CFAN-M during the response period, regardless of whether there is the request from the CFAN-M. In the extended CFAN, the sub CFAN-M transmits data to the CFAN-R. The data frame may be configured as shown in Table 10. A unit in row 1 of Table 10 is a byte.

**[Table 10]**

| **8** | **8** | **L** | **2** |
|---|---|---|---|
| Frame header | UID | Data | Frame check sequence |
| | Data frame payload | | |
| | Frame body | | |

Types of acknowledgement frames include a response acknowledgement (RA) frame and a data acknowledgement (DA) frame. When the main CFAN-M transmits the request frame in an RA frame, the CFAN-S, the CFAN-R, or the sub CFAN-M receives the request packet and transmits the response packet, and the main CFAN-M transmits the response packet and transmits the RA packet. RA data for the received response packet is recorded on the payload of the acknowledgement frame. The main CFAN-M, which receives the appropriate response frame, transmits the RA frame after a short frame interval of the request period to respond to the transmitted CFAN-S, CFAN-R, or sub CFAN-M. The DA frame is an acknowledgement frame for the received data packet. The main CFAN-M transmits the DA frame after the short frame interval in the response period to respond to the CFAN-S, the CFAN-R, or the sub CFAN-M, which has transmitted the data packet. In the extended CFAN, the CFAN-R responds to the sub CFAN-M that transmits the response or data packet by transmitting the RA or DA frame during a response cycle. Table 11 is an example of the format of the response acknowledgment frame. A unit in row 1 of Table 11 is a byte.

**[Table 11]**

| **8** | **1** | **1** | **1** | **L1** | **L2** | **...** | **Ln** | **2** |
|---|---|---|---|---|---|---|---|---|
| Frame header | Group ID | Response Confirma tion code | Length (= Σ Ln) | Response Confirma tion block k-1 | Response Conform ation block k-2 | ... | Response Conform ation block-n | Response Check sequence |
| | Acknowledgment frame payload | | | | | | | |
| | Frame body | | | | | | | |

Table 12 and the DA frame is composed of the frame header and the frame body. When the destination CFAN ID is 0xFF, and the destination node ID is 0xFE or 0xFD, the destination CFAN ID and the destination node ID correspond to an unjoined CFAN-S ID and an unjoined CFAN-R ID, respectively. In this case, the destination CFAN ID and the destination node ID should include the UID field.

**[Table 12]**

| **2 bytes** | **1 byte** | **1 byte** | **1 byte** | **1 byte** | **1 byte** | **8 (option)** | **2 bytes** |
|---|---|---|---|---|---|---|---|
| Frame control | Source CFAN ID | Source address | Destination CFAN ID | Destination address | Sequence number | UID | Frame check sequence |
| Frame header | | | | | | Frame body | |

### (4) Payload Format

A payload format is generated in a different manner depending on the frame type that includes the request frame, the response frame, the data frame, the acknowledgment frame, etc.

### [Request Frame]

Table 13 relates to a payload format of the request frame. As shown in Table 13, the payload for the request frame is composed of a group ID, a request code, a length, and one or more request blocks according to the request. A unit in row 1 of Table 13 is a byte.

**[Table 13]**

| **1** | **1** | **1** | **LI** | **L2** | **...** | **Ln** |
|---|---|---|---|---|---|---|
| Group ID | Request code | Length (=Σ Ln) | Request block-1 | Request block-2 | ... | Request block-n |

The group ID field is composed of 1 byte and is used to transmit the RR packet to a specific group. When the group ID is 0xFF, the group ID indicates that the CFAN-M requests a response from all of the CFAN-S, CFAN-R, and sub CFAN-M groups. Details related to the group ID are described above.

The request code in the payload of the request frame may be configured as shown in Table 14.

**[Table 14]**

| **Category** | **Request code** | **Content** | **Remarks** |
|---|---|---|---|
| Network | 0x01 | Association request | Request for association response to unjoined nodes |
| | 0x02 | Disassociation request | Request for disassociation response to joined nodes |
| | 0x03 | Association status request | Request for association status response to joined nodes |
| | 0x04-0x0F | Reserved | - |
| Data | 0x11 | Data request | Request for data transmission to joined nodes |
| | 0x12-0x1F | Reserved | - |
| Configuration | 0x21 | Group ID set-up | Group ID change request to joined nodes |
| | 0x22-0x2F | Reserved | - |
| Reserved | 0x31-0xFF | Reserved | - |

A length field is composed of 1 byte. The length field indicates the total length of the request block, and the length field value varies depending on the length and number of request blocks. The data format of the request block is configured in a different manner according to the request code, and one or more request blocks may be included in the payload of the request frame.

The details of the data format of each request block are as follows.

### 1) Association Request

A block format of the ARQ may be configured as shown in Table 15 and is composed of an 8-byte UID mask. This UID mask may be used to implement a binary search algorithm.

**[Table 15]**

| **8 bytes** |
|---|
| UID mask |

### 2) Disassociation Request

A block format of the DARQ may be configured as shown in Table 16. The first and second bytes constitute the CFAN ID and the node ID of the CFAN-S, the CFAN-R, or the sub CFAN-M for the DARQ, and the next 1 byte constitutes a slot number to be used for the response period. When the node ID is 0xFF, the DARQ is transmitted to all of the CFAN-Rs and the CFAN-S within the group ID.

**[Table 16]**

| **1 byte** | **1 byte** | **1 byte** |
|---|---|---|
| CFAN ID | Node ID | Slot number |

### 3) Association Status Request

A block format of the ASRQ may be configured as shown in Table 17. The first and second bytes constitute the CFAN ID and the node ID of the CFAN-S, the CFAN-R, or the sub CFAN-M for the ASRQ. When the CFAN ID is 0xFF and the node ID is 0xFF, the ASRQ is requested from all of the CFAN-R and the CFAN-S within the group ID.

**[Table 17]**

| **1 byte** | **1 byte** | **1 byte** |
|---|---|---|
| CFAN ID | Node ID | Slot number |

### 4) Data Request

A block format of the DRQ may be configured as shown in Table 18. The first and second bytes constitute the CFAN ID and the node ID, the next 1 byte constitutes the slot number, and the last L byte constitutes the received data type. The data type is determined according to an application product.

**[Table 18]**

| **1 byte** | **1 byte** | **1 byte** | **L Bytes** |
|---|---|---|---|
| CFAN ID | Node ID | Slot number | Data |

### 5) Group ID Set-up Request

A block format of the GSRQ may be configured as shown in Table 19. The first and second bytes constitute the CFAN ID and the node ID, the next 1 byte constitutes the slot number, and the last byte constitutes the group ID to be set up.

**[Table 19]**

| **1 byte** | **1 byte** | **1 byte** | **L Bytes** |
|---|---|---|---|
| CFAN ID | Node ID | Slot number | Group ID |

### [Response Frame]

Table 20 relates to a payload format of the response frame. The payload format of the response frame has response information for the request of the CFAN-M. In the extended CFAN, the payload format has response information for the request of the CFAN-R. The first byte constitutes a group ID, the second byte constitutes a response code, the third byte constitutes a response data length L, and the next L byte constitutes the response data. A unit in row 1 of Table 20 is a byte.

**[Table 20]**

| **1** | **1** | **1** | **LI** | **L2** | **...** | **Ln** |
|---|---|---|---|---|---|---|
| Group ID | Response code | Length (=Σ Ln) | Response block-1 | Response block-2 | ... | Response block-n |

A group address field is composed of 1 byte and is used to transmit the RR packet to a specific group. Details of the group ID are described above.

Table 21 illustrates the response code included in a response frame payload. A response code type may be configured as shown in Table 21.

**[Table 21]**

| **Category** | **Response** | **Content** | **Remarks** |
|---|---|---|---|
| Network | 0x01 | Association response | Transmission of node UID |
| | 0x02 | Disassociation response | Transmission of node UID |
| | 0x03 | Association status response | Transmission of node UID |
| | 0x04 - 0x0F | Reserved | - |
| | 0x11 | Data response | Transmission of request data |
| Data | 0x12 - 0x1F | Reserved | - |
| Set-up | 0x21 | Group ID set-up response | Transmission of UID and group ID after changes in group ID |
| | 0x22 - 0x2F | Reserved | - |
| Reserved | 0x40 - OxFF | Reserved | - |

The length field is composed of 1 byte and indicates a length of the response data. The length field varies depending on the response data.

A response data format is divided as follows:

### 1) Association Response

A block format of the ARS may be configured as shown in Table 22. ARS data is composed of an 8-byte UID.

**[Table 22]**

| **8 bytes** |
|---|
| UID |

### 2) Disassociation Response

A block format of the DARS may be configured as shown in Table 23. DARS data is composed of an 8-byte UID.

**[Table 23]**

| **8 bytes** |
|---|
| UID |

### 3) Association Status Response

A block format of the ASRS may be configured as shown in Table 24. ASRS data may be composed of an 8-byte UID and a 1-byte status value. Table 25 is a table regarding an association status check value.

**[Table 24]**

| **8 bytes** | **1 byte** |
|---|---|
| UID | Status value |

**[Table 25]**

| **Value** | **Content** |
|---|---|
| 0x00 | Disassociation status |
| 0x01 | Association status |
| 0x02 - OxFF | Reserved |

### 4) Data Response

A block format of the DRS may be configured as shown in Table 26. Data of DRS is composed of 1 byte for the CFAN ID, 1 byte for the node ID, and an L byte of the requested data.

**[Table 26]**

| **1 byte** | **1 byte** | **L bytes** |
|---|---|---|
| CFAN ID | Node ID | Requested Data |

### 5) Group ID Set-Up Response

A block format of the GSRS may be configured as shown in Table 27. GSRS data is composed of 8 bytes for the UID with the changed group ID and 1 byte for the changed group ID.

**[Table 27]**

| **8 bytes** | **1 byte** |
|---|---|
| UID | Assigned group ID |

### [Data Frame]

A payload of the data frame includes data to be transmitted. Table 28 relates to a payload format of the data frame. The data frame is composed of an 8-byte UID and L-byte data.

**[Table 28]**

| **8 bytes** | **L bytes** |
|---|---|
| UID | Data |

### [Acknowledgement Frame]

A payload of the RA frame includes data related to the received response packet. Table 29 is a table regarding a payload format of the acknowledgement frame. The first byte constitutes the group ID, the second byte constitutes a response acknowledgement code, the third byte constitutes the length L, and the next L byte constitutes a response acknowledgement block. A unit in row 1 of Table 29 is a byte.

**[Table 29]**

| **1** | **1** | **1** | **LI** | **L2** | **...** | **Ln** |
|---|---|---|---|---|---|---|
| Group ID | Response Confirmation code | Length (=Σ Ln) | Response Confirmation block-1 | Response Confirmation block-2 | ... | Response Confirmation block-n |

The group ID field is composed of 1 byte and is used to transmit the RR packet to a specific group. Details of the group ID are described above.

Table 30 is a table regarding the response acknowledgement code. The response acknowledgement code type may be configured as shown in Table 30.

**[Table 30]**

| **Category** | **Reception confirmation code** | **Content** | **Remarks** |
|---|---|---|---|
| Network | 0x01 | Association response confirmation | UID and assigned node ID transmission of nodes |
| | 0x02 | Disassociation response confirmation | UID and node ID transmission of nodes |
| | 0x03 | Association status response confirmation | UID transmission of nodes |
| | 0x04 - OxOF | Reserved | - |
| Data | 0x11 | Data response confirmation | Confirmation of data transmission to a joined node |
| | 0x12 - OxlF | Reserved | - |
| Set-up | 0x21 | Group ID set-up response confirmation | UID and group ID transmission after group ID changes |
| | 0x23 - 0x2F | Reserved | - |
| Reserved | 0x31 -OxFF | Reserved | - |

The length field is composed of 1 byte. The length field indicates a length of the response acknowledgement data and varies depending on the response acknowledgement data.

The response acknowledgement block format is classified as follows.

### 1) Association Response Confirmation

A block format of the ARS acknowledgement (ARA) may be configured as shown in Table 31. The first 8 bytes constitute the UID, and the next 2 bytes constitute the assigned CFAN ID and the assigned node ID. When the assigned CFAN ID is 0xFF and the assigned node ID is 0xFE or 0xFD, the assigned CFAN ID and the assigned node ID correspond to the addresses of the unjoined CFAN-S and the unjoined CFAN-R, respectively, which means that the ARQ is denied.

**[Table 31]**

| **8 bytes** | **1 byte** | **1 byte** |
|---|---|---|
| UID | Assigned CFAN ID | Assigned node ID |

### 2) disassociation response confirmation

A block format of the DARS acknowledgment (DARA) may be configured as shown in Table 32. The first 8 bytes constitute the UID, and the next 2 bytes constitute the CFAN ID and the node ID. The assigned CFAN ID and node ID are used if disassociation is not allowed. When the disassociation is not allowed, 0xFF is recorded for the unjoined CFAN, and 0xFE or 0xFD is recorded for the unjoined CFAN-S ID or the unjoined CFAN-R, respectively.

**[Table 32]**

| **8 bytes** | **1 byte** | **1 byte** |
|---|---|---|
| UID | CFAN ID | Node ID |

### 3) association status response confirmation

A block format of the ASR acknowledgement (ASRA) may be configured as shown in Table 33. An ASR acknowledgement block is composed of an 8-byte UID.

**[Table 33]**

| **8 bytes** |
|---|
| UID |

### 4) Data Response Confirmation

A block format of the DR acknowledgment (DRA) may be configured as shown in Table 34. The first two bytes constitute the CFAN ID and the node ID, and the next 1 byte is reserved.

**[Table 34]**

| **1 byte** | **1 byte** | **1 byte** |
|---|---|---|
| CFAN ID | Node ID | Reserved |

### 5) Group ID Set-Up Response Confirmation

A block format of the GSR acknowledgement (GAIRA) may be configured as shown in Table 35. A GSRS acknowledgement block is composed of an 8-byte UID and a 1-byte status check value (set-up status value).

**[Table 35]**

| **8 bytes** | **1 byte** |
|---|---|
| UID | Group ID set-up status value |

A group ID set-up status value may be configured as shown in Table 36.

**[Table 36]**

| **Value** | **Content** |
|---|---|
| 0x00 | Change completed |
| 0x01 | Change failed |
| 0x02-0xFF | Reserved |

### MAC Layer Function

### (1) General

In a MAC layer of the CFAN, association, disassociation, and ASC processes are used to manage the CFAN network. The data transmission may occur in the response period or the spontaneous period. In addition, a group address initialization function is provided for managing the CFAN-S, CFAN-R, and sub CFAN-M groups.

### (2) Network Association and Disassociation

In order for the CFAN-R or the CFAN-S to communicate with the CFAN-M, the CFAN-R or the CFAN-S should first be associated with the CFAN. Each CFAN-R and the CFAN-S searches for the previously formed CFAN, and when the search is successful, they are associated with the corresponding CFAN. In the extended CFAN, the sub CFAN should be associated with the main CFAN.

### [Association]

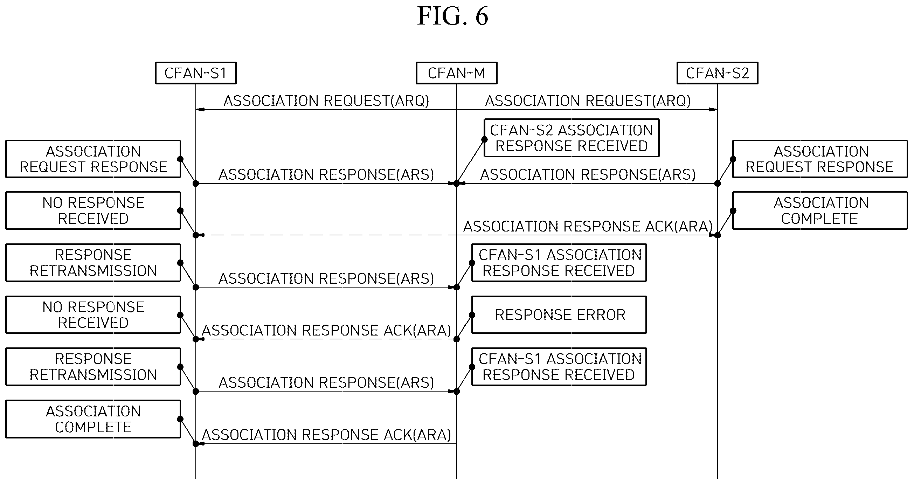

FIG. 6 is a diagram illustrating a method of associating a CFAN. When the CFAN-M transmits an ARQ packet to the CFAN-R or the CFAN-S that is not yet associated with the CFAN during the request period, the CFAN-R or the CFAN-S transmits an ARS packet to the CFAN-M during the response period. The CFAN-M determines the association status of the CFAN with the appropriate CFAN-R or CFAN-S and notifies the result through the RA packet. When the association is allowed, the assigned node address ID is included in the RA packet, and when the association is denied, a default CFAN ID and node ID are recorded accordingly. The CFAN-M continues to transmit the ARS packet in each superframe until the CFAN-M receives the ARA packet when the CFAN-M may not receive the ARS packet or the CFAN-R or the CFAN-S may not receive the RA packet due to a data error of the RA packet. The association is completed when the CFAN-R or the CFAN-S receives the RA packet from the CFAN-M.

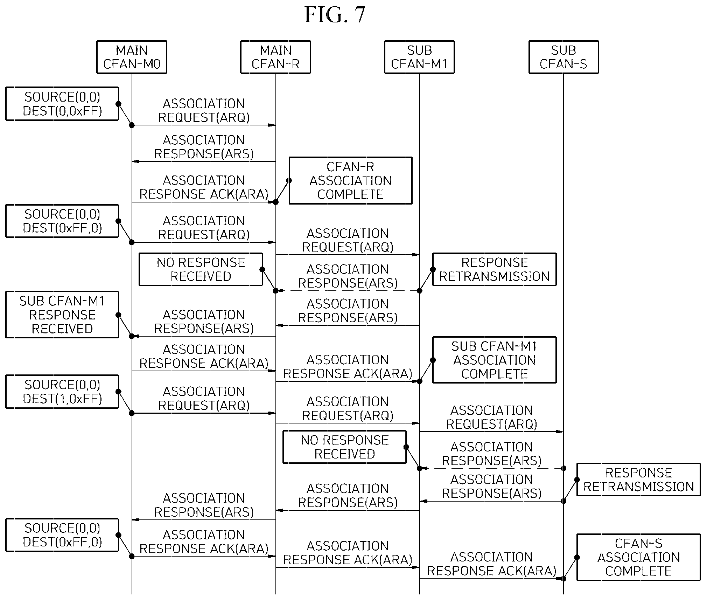

FIG. 7 is a diagram illustrating a method of associating an extended CFAN. In the extended CFAN, the main CFAN-M transmits the association request packet (ARQ packet) to the CFAN-S of the sub CFAN that is not yet associated with the CFAN through the CFAN-R and the sub CFAN-M. Then, the CFAN-S transmits the association response packet (ARS packet) to the main CFAN-M through the sub CFAN-M and the CFAN-R, and after receiving the association response, the main CFAN-M determines the appropriate association status of the CFAN-S for the CFAN. The result is notified through the ARA packet. When the association is allowed, the assigned CFAN ID and the assigned node ID are included in the ARA packet, and when the association is denied, the default CFAN ID and the default node ID are recorded accordingly.

### [Disassociation]

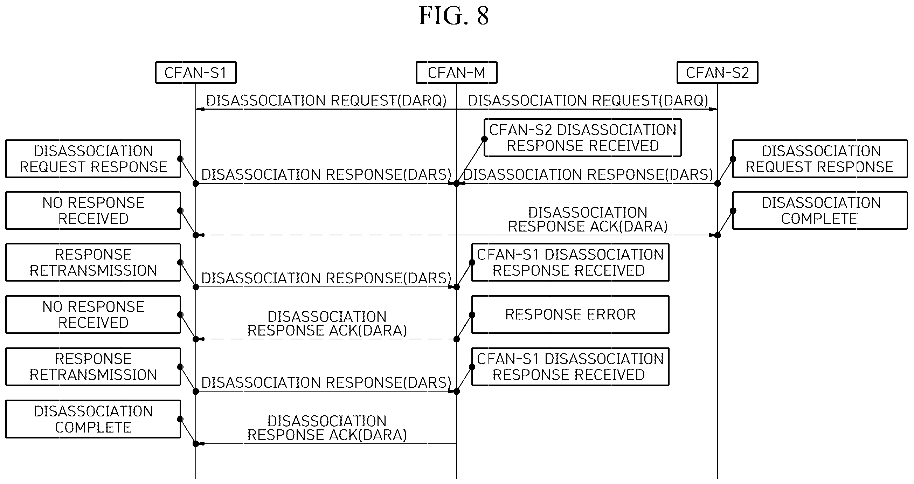

FIG. 8 is a diagram illustrating a method of disassociating a CFAN. When the CFAN-M transmits a disassociation request packet (DARQ packet) to the CFAN-R or the CFAN-S associated with the CFAN during the request period, the CFAN-R or the CFAN-S transmits a disassociation response packet (DARS packet) to the CFAN-M during the response period. The CFAN-M determines the disassociation status of the appropriate CFAN-R or CFAN-S from the CFAN and notifies the result through a disassociation response acknowledgement packet (DARA packet). When the disassociation is allowed, the CFAN ID and node ID addresses of the DARA packet are recorded as the default CFAN ID and the default node ID, and when the disassociation is denied, the existing node ID address is recorded. When the CFAN-M does not receive the DARS packet, or when the CFAN-R or the CFAN-S attempting to separate may not receive the DARA packet due to a data error in the DARA packet transmitted by the CFAN-M even though CFAN-M has received the DARS packet, the CFAN-R or the CFAN-S continues to retransmit the DARS packet to the CFAN-M every superframe until it receives the DARA packet. The association is completed when the CFAN-R or the CFAN-S receives the DARA packet from the CFAN-M.

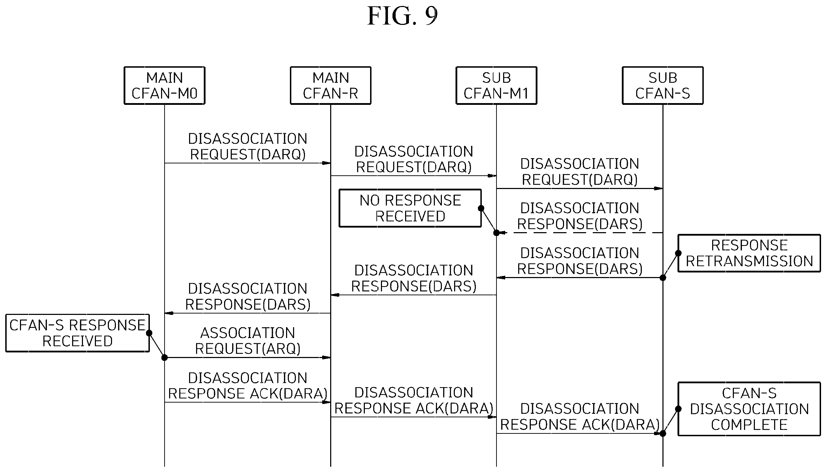

FIG. 9 is a diagram illustrating a method of disassociating an extended CFAN. In the extended CFAN, the main CFAN-M transmits the DARQ packet to the CFAN-S of the sub CFAN that is associated with the CFAN through the CFAN-R and the sub CFAN-M. Then, the CFAN-S transmits the DARS packet to the main CFAN-M through the sub CFAN-M and the CFAN-R, and after receiving the association response, the main CFAN-M determines the appropriate disassociation status of the CFAN-S for the CFAN and notifies the result through the DARA packet. When the disassociation is allowed, the CFAN ID and node ID addresses of the DARA packet are recorded as the default CFAN ID and the default node ID, and when the disassociation is denied, the existing CFAN ID and node ID addresses are recorded.

### [Association Status Check]

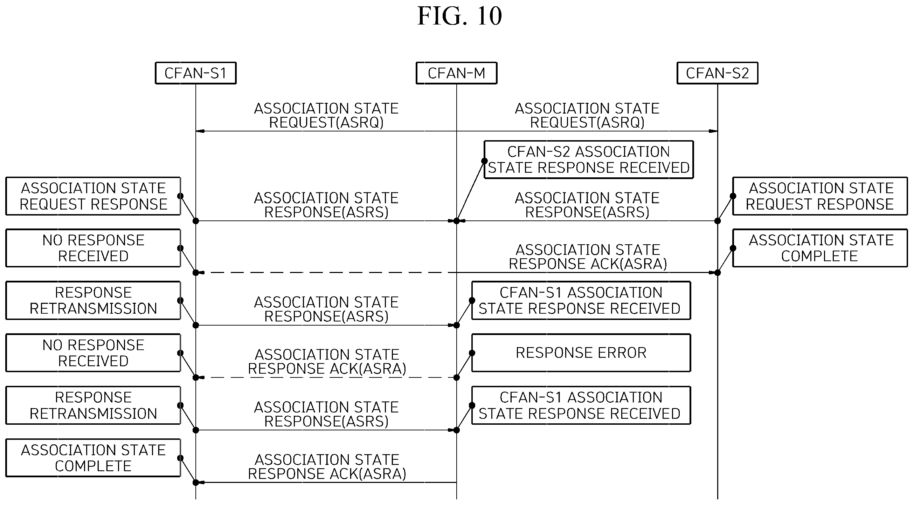

FIG. 10 is a diagram illustrating an association status confirmation method of the CFAN. During the request period, the CFAN-M transmits an association status request packet (ASRQ packet) to the CFAN-R or the CFAN-S associated with the CFAN, and the CFAN-R or the CFAN-S transmits an association status response packet (ASRQ packet) to the CFAN-M during the response period. The CFAN-M checks an association status response acknowledgement packet (ASRA packet) for the association status of the appropriate CFAN-R or CFAN-S and transmits the checked association status response acknowledgment packet to the CFAN. When the CFAN-M may not receive the ASRS packet or the CFAN-R or the CFAN-S attempting to transmit the ASRS packet may not receive the ASRA packet due to a data error of the ASRA packet, the CFAN-R or the CFAN-S continues to transmit the ASRS packet to the CFAN-M every superframe until the CFAN-R or the CFAN-S receives the ASRA packet. The ASRS is completed when the CFAN-R or the CFAN-S receives the ASRA packet from the CFAN-M. That is, the association status check is completed when the CFAN-R or the CFAN-S receives the ASRA packet from the CFAN-M.

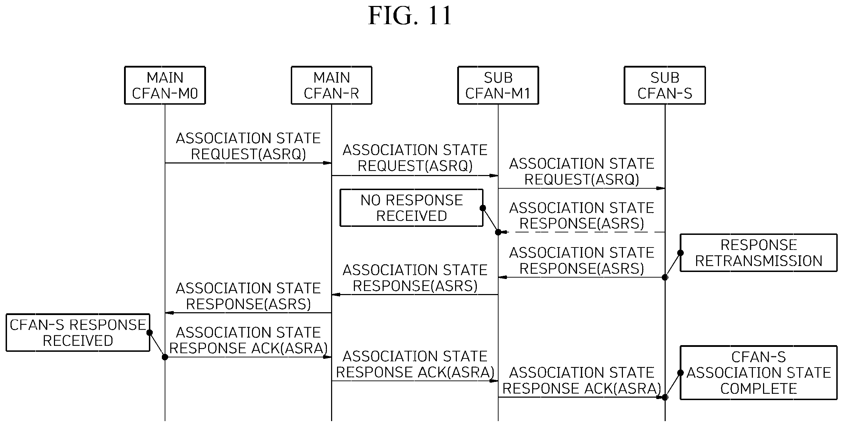

FIG. 11 is a diagram illustrating an association status confirmation method of the extended CFAN. In the extended CFAN, the main CFAN-M transmits the ASRQ packet to the CFAN-S of the sub CFAN through the CFAN-R and the sub CFAN-M. Next, the CFAN-S transmits the ASRS packet to the main CFAN-M through the sub CFAN-M and the CFAN-R, and the main CFAN-M determines the appropriate association status of the CFAN-S with respect to the CFAN after receiving the ASRS packet and transmits the result through the ASRA packet.

### (3) Data Transmission

The time at which data may be transmitted in the CFAN is the response period or the spontaneous period. During the response period, data may be transmitted according to a request from the CFAN-M, and during the spontaneous period, data may be transmitted without the request from the CFAN-M.

### [Data Transmission during Response Period]

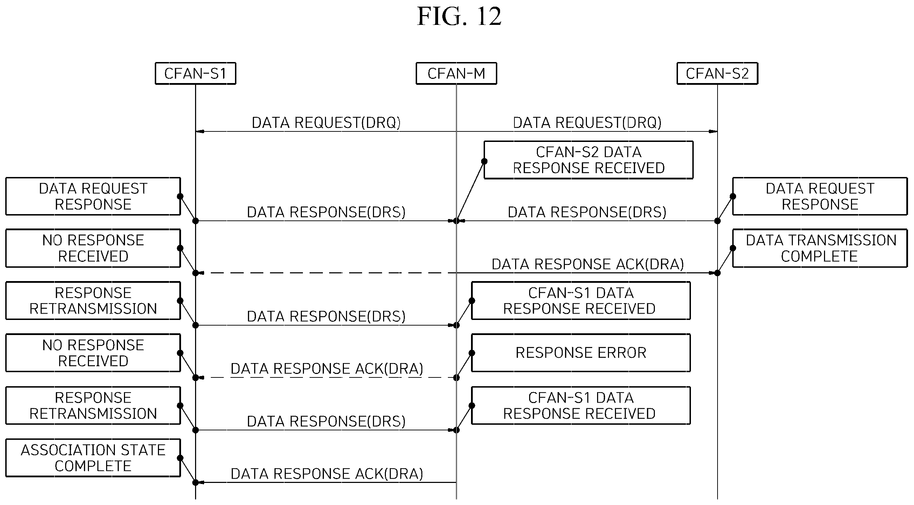

FIG. 12 is a diagram illustrating a data transmission method of the CFAN during the response period. When the CFAN-M transmits a data request packet (DRQ packet) to the CFAN-R or the CFAN-S associated with the CFAN during the request period, the CFAN-R or the CFAN-S transmits a data response packet (DRS packet) during the response period. The CFAN-M receives the DRS packet from the CFAN-R or the CFAN-S and then transmits a data response acknowledgement packet (DRA packet). When the CFAN-M does not receive the DRS packet of the CFAN-R or the CFAN-R or the CFAN-S does not receive the DRA packet due to a packet error, the CFAN-R or the CFAN-S continues to transmit the DRS packet in every time slot until the CFAN-R or the CFAN-S receives the DRA packet. When the CFAN-R or the CFAN-S receives the DRA packet from the CFAN-M, the data transmission procedure during the response period is completed.

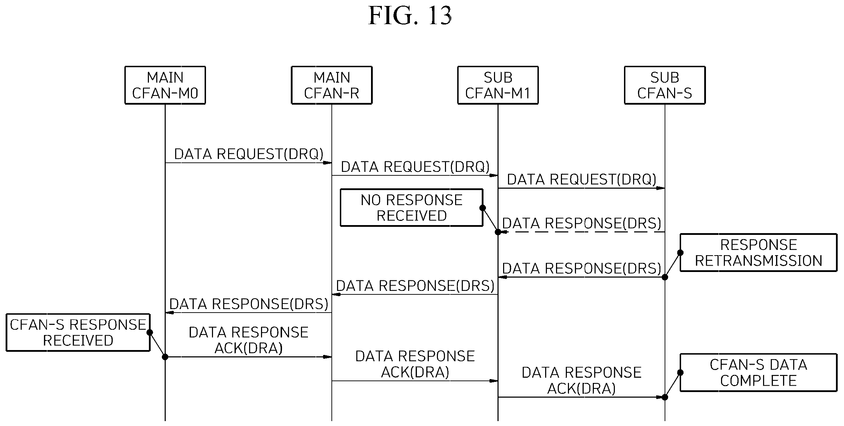

FIG. 13 is a diagram illustrating a data transmission method of the extended CFAN during the response period. In the extended CFAN, the main CFAN-M transmits the DRQ packet to the CFAN-S of the sub CFAN through the CFAN-R and the sub CFAN-M. Then, the CFAN-S transmits the DRS packet to the main CFAN-M through the sub CFAN-M and the CFAN-R, and the main CFAN-M which receives the response transmits the DRA packet to the CFAN-S. The data transmission procedure during the response period is completed when the CFAN-S receives the DRA packet from the CFAN-M.

### [Data Transmission during Spontaneous Period]

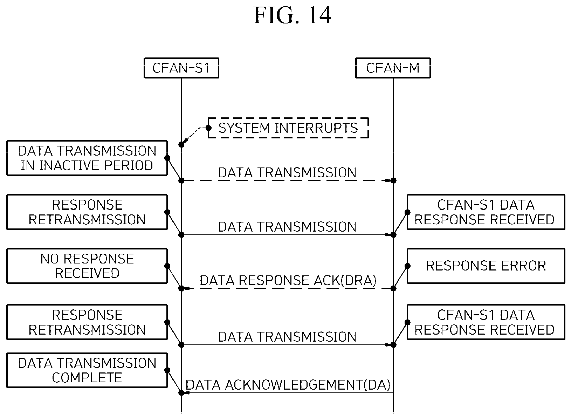

FIG. 14 is a diagram illustrating a data transmission method of the CFAN during the spontaneous period. The spontaneous period starts when the CFAN-R or the CFAN-S does not transmit the response packet during the timeout period. The spontaneous period continues until the CFAN-M transmits the RR packet. The CFAN-R or the CFAN-S may transmit data without a request from the CFAN-M during the spontaneous period. When a system outage occurs, the CFAN-R or the CFAN-S may transmit data without the request from the CFAN-M. When the CFAN-M does not receive the data packet or the CFAN-R or the CFAN-S does not receive the DA packet due to a packet error, the CFAN-S continues to transmit the data packet to the CFAN-M until the CFAN-S receives the DA packet. When the CFAN-R or the CFAN-S receives the DA packet from the CFAN-M, the data transmission procedure during the spontaneous period is completed.

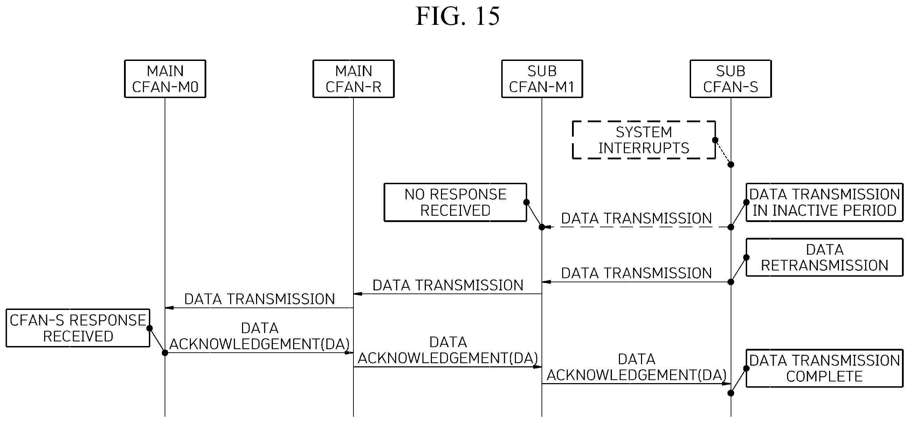

FIG. 15 is a diagram illustrating a data transmission method of the extended CFAN during the spontaneous period. In the extended CFAN, the CFAN-S of the sub CFAN may transmit data during the spontaneous period without the request from the main CFAN-M. When the system outage occurs, the CFAN-S may transmit data without the request from the main CFAN-M.

### (4) Group ID Set-Up

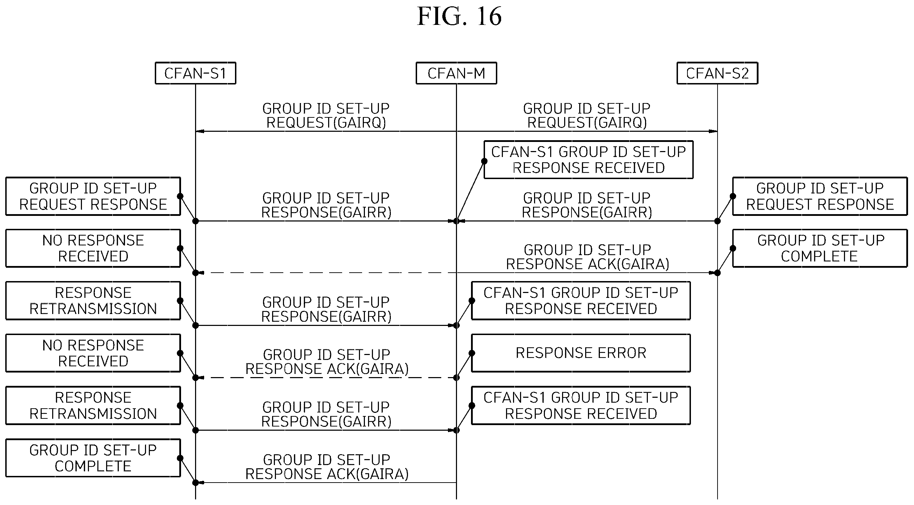

FIG. 16 is a diagram illustrating a group ID set-up method. When the CFAN-M transmits a group ID set-up request packet (GAIRQ packet) to the CFAN-R or the CFAN-S associated with the CFAN during the request period, the CFAN-R or the CFAN-S transmits a group ID set-up response packet (GAIRR packet) during the response period. The CFAN-M acknowledges a group address initialization status of the corresponding CFAN-R or CFAN-S and then transmits a group ID set-up response acknowledgement packet (GAIRA packet).

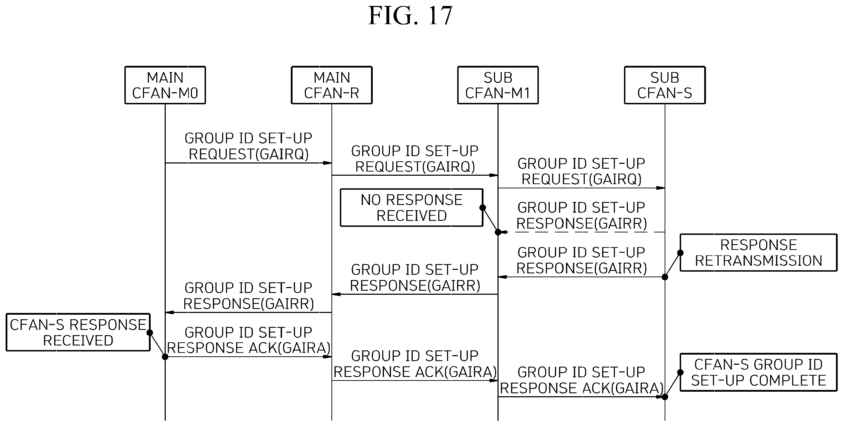

FIG. 17 is a diagram illustrating a group ID set-up method of the extended CFAN. When the main CFAN-M transmits the GAIRQ packet to the CFAN-S of the sub CFAN associated with the CFAN during the request period in the extended CFAN, the CFAN-S transmits a GAIRR response packet through the sub CFAN-M and the CFAN-R. The main CFAN-M checks the group address initialization status of the corresponding CFAN-S and then transmits the GAIRA packet.

### PHY LAYER

### (1) PHY Layer Frame Format

### [General]

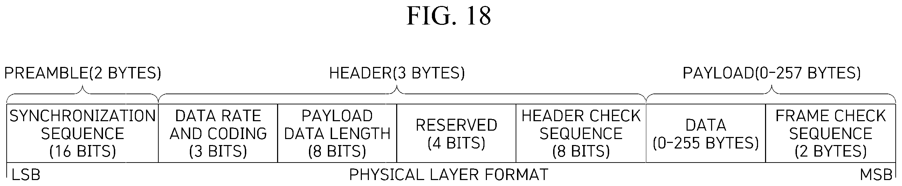

A physical layer (PHY layer) frame format of the CFAN will be described below. FIG. 18 is a diagram illustrating the physical layer frame format. Each physical layer frame is composed of a preamble, a header, and a payload. As illustrated in FIG. 18, the physical layer frame is composed of three parts such as the preamble, the header, and the payload. When transmitting the packet, the preamble is first transmitted, the header is transmitted, and the payload is finally transmitted. The transmission and reception of the packet starts from the LSB.

### [Preamble]

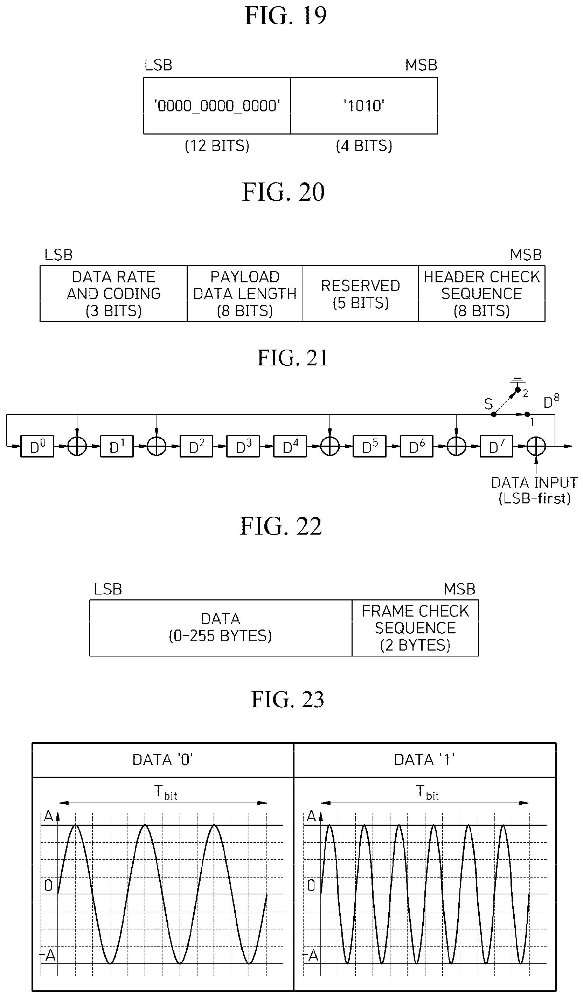

FIG. 19 is a diagram illustrating a preamble format. As illustrated in FIG. 19, the preamble is composed of one part called a synchronization sequence. A 16-bit synchronization sequence is composed of a 12-bit sequence [0000 0000 0000]. A 4-bit sequence of [1010] follows the synchronization sequence. The synchronization sequence is used for packet acquisition, symbol timing, and carrier frequency estimation.

The preamble is coded using TYPE 0, which will be described later.

### [Header]

FIG. 20 is a diagram illustrating a header format. The header is added after the preamble to transmit the information related to the payload. As illustrated in FIG. 20, the header is composed of 24 bits. Bits 0 to 2 constitute a data rate and a coding field. Bits 3 to 10 constitute payload data length fields. Bits 16 to 23 constitute a cyclic redundancy check-8 header check sequence (CRC-8 HCS). The header is coded using TYPE 0, which will be described later. Table 37 is a table regarding the header definition of the physical layer.

**[Table 37]**

| **Bit** | **Content** | **Description** |
|---|---|---|
| b2-b0 | Data rate and coding | Specifies the data rate and coding at which the payload is received (see Table 38) |
| blO-b3 | Payload data length | Specifies the number of octets in the payload (which is not included in FCS) |
| bl5-bll | Reserved | Reserved and set to zero |
| b23-bl6 | Header check sequence | Provides a CRC-8 HCS (see description of header check sequence) |

Table 38 is a definition table regarding the data rate, modulation, and the coding. Bits 0 to 2 may be set to values shown in Table 38 according to the data rate and coding. However, the data rate in Table 38 may be changed to other values. Details of TYPES 0 to 7 will be described below.

**[Table 38]**

| **Type** | **Value (b2 b1 b0)** | **Data rate** | **Modulation and coding** |
|---|---|---|---|
| TYPE0 | 000 | 32 kbps | GFSK + NRZ-L |
| TYPE 1 | 001 | 128 kbps | GFSK + NRZ-L |
| TYPE 2 | 010 | 512 kbps | GFSK + NRZ-L |
| TYPE 3 | Oil | 1024 kbps | GFSK + NRZ-L |
| TYPE 4 | 100 | 1 kbps | ASK + NRZ-L |
| TYPE 5 | 101 | 2 kbps | ASK + NRZ-L |

A payload data length is represented by an unsigned 8-bit integer. The payload data length represents the number of octets of the payload that does not include the FCS. A range of the payload data length is from 0x00 to up to 0xFF bytes.

The CRC-8 HCS is used to check whether there are the errors in the header. The HCS handles the data rate and coding, the payload data rate, and 5 reserved bits. A primitive polynomial is given as provided in Equation 2. [Equation 2] $g \left(D\right) = \left(1+D\right) \left(1={D}^{2}+{D}^{3}+{D}^{4}+{D}^{7}\right) = 1 + D + {D}^{2} + {D}^{5} + {D}^{7} + {D}^{8}$

FIG. 21 is a diagram illustrating an encoder of the header check sequence. The processing order of the header check is as illustrated in FIG. 21. All registers are initialized to 0.

Data is accumulated while a switch "S" of FIG. 21 is at "1". When the last bit is accumulated, the switch S moves to "2", and the HCS is transmitted from the register starting from D7.

### [Payload]

FIG. 22 is a diagram illustrating the payload format. As illustrated in FIG. 22, the payload is composed of variable length data and the FCS. When the payload data length field of the header is 0, the FCS is not transmitted.

### [Frame Check Sequence (FCS)]

The CRC-16 FCS defined in Table 39 is used to check for errors in the payload. The FCS handles the variable length data. The primitive polynomial is X¹⁶ + X¹² + X⁵ + 1. The registers are initialized to all ones. The frame check sequence is obtained by inverting the calculated CRC-16 bits.

**[Table 39]**

| **CRC** | **Length** | **Polynomial** | **Preset** | **Residue** |
|---|---|---|---|---|
| ISO/IEC 13239 | 16 bits | X¹⁶+X¹²+X⁵+1 | OxFFFF | Ox1DOF |

### (2) Coding and Modulation

### [Coding]

FIG. 23 is a diagram illustrating a definition of non-return-to-zero level (NRZ-L) coding. In the NRZ-L (level), 0 is represented by frequency ω₁, and 1 is represented by frequency ω₂.

### [Data Rate and Coding Type]

The physical layer supports 8 types as shown in Table 38.

The preamble and the header are encoded with TYPE 0, but the payload is encoded using the appropriate data rate and coding. The data rate and coding type of the payload are designated in the data rate and coding field of the header.

### [Modulation]

The communication between the CFAN-M, the CFAN-R, and the CFAN-S uses GFSK modulation or ASK modulation.

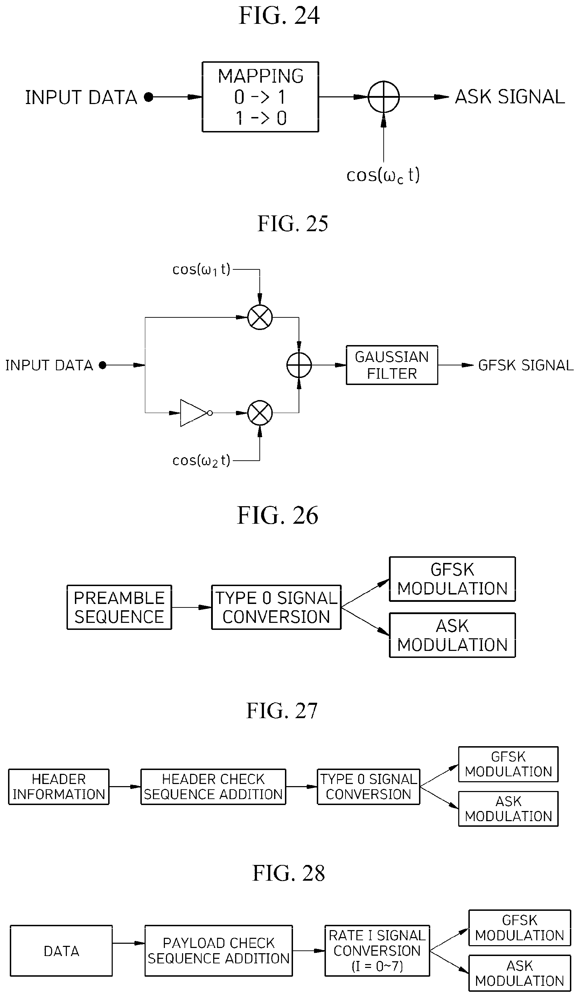

FIG. 24 is a diagram illustrating amplitude-shift keying (ASK) modulation. As illustrated in FIG. 24, the encoded serial input data is converted into a number representing one of two ASK constellation points. (ω_{c} denotes the carrier frequency of the CFAN)

FIG. 25 is a diagram for GFSK modulation. As illustrated in FIG. 25, the encoded serial input data is converted into a number representing one of two GFSK constellation points. (ω₁ and ω₂ denote the modulation frequencies of the CFAN.)

### [Coding and Modulation Process]

FIG. 26 is a diagram for a coding and modulation process of a preamble. The preamble sequence is encoded using TYPE 0.

FIG. 27 is a diagram for a coding and modulation process of the header. As illustrated in FIG. 27, the header is formatted by adding the data rate and coding, the payload data length, 5-bit 0, and HCS values. The resulting combination of the values is encoded using TYPE 0 and then modulated by the GFSK or ASK.

FIG. 28 is a diagram for a coding and modulation process of the payload. As illustrated in FIG. 28, the payload is formatted by attaching the data and FCS values. The FCS value is a value calculated for the data. The resulting combination is encoded using TYPE 1 and then modulated by the GFSK or ASK.

### Medium Interface

### (1) Frequency

A center frequency of the CFAN is ω₁ and ω₂ with a maximum allowable error of ±20 ppm for the GFSK or ω_{c} with a maximum allowable error of ±20 ppm for the ASK.

### (2) Signal Waveform

The GFSK and ASK modulation are used for transmission between the CFAN-M, the CFAN-R, and the CFAN-S.

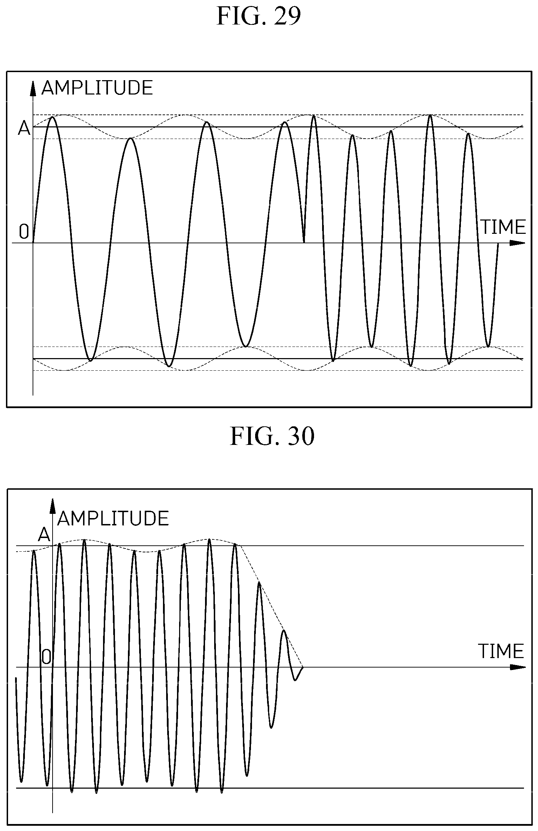

FIG. 29 is a diagram for a GFSK modulation signal, and FIG. 30 is a diagram for an ASK modulation signal. As illustrated in FIGS. 29 and 30, the transmitted signal is modulated by the GFSK and ASK according to the envelope defined in this specification. Table 40 is an example of a table regarding envelope parameters of the GFSK.

**[Table 40]**

| **Parameter** | **Symbol** | **Min.** | **Max.** |
|---|---|---|---|
| Positive variation | Mₕ | 0 | |
| Negative variation | M_{I} | 0 | |
| Rising time | tᵣ | 0 | |
| Falling time | t_{f} | 0 | |

### Network Design (Implementation Example of CFAN)

Several examples of CFAN implementation according to the present invention are presented.

The physical structure of the CFAN will be described. The CFAN may be implemented in various designs based on a structure with two conductive materials and a dielectric material between the conductors. For example, e-textile may be designed to have two conductive fabric layers separated by a dielectric layer as illustrated in FIG. 31. When one conductive fabric layer is Vcc and the other layer is the ground, the CFAN may be implemented. Therefore, power and data may be transmitted through the physical structure according to this layer design. In FIG. 31, ① denotes the Vcc, ② denotes the ground, ③ denotes the dielectric, and ④ denotes the e-textile.

As another example, the CFAN capable of transmitting the power and data may be designed based on a linear cable. A flexible coaxial cable may have multiple layers composed of inner and outer conductive layers and a dielectric material layer therebetween as illustrated in FIG. 32. The design selection of the coaxial cable affects the size, the data transmission, the power attenuation, the strength, the flexibility, and the cost. In FIG. 32, ① denotes the Vcc, ② denotes the ground, ③ denotes the dielectric, and ④ denotes the coaxial cable.

In addition, the CFAN may be designed using a non-conductive material (insulating material) and a conductive material arranged in parallel in two regions. The two regions may be configured to be parallel to each other. For the design of the CFAN included in clothing as illustrated in FIG. 33, the conductive fabric may be used as the conductive material, and a general fabric may be used as the insulating material. In FIG. 33, ① denotes the Vcc, ② denotes the ground, ③ denotes general fiber, and ④ denotes clothing.

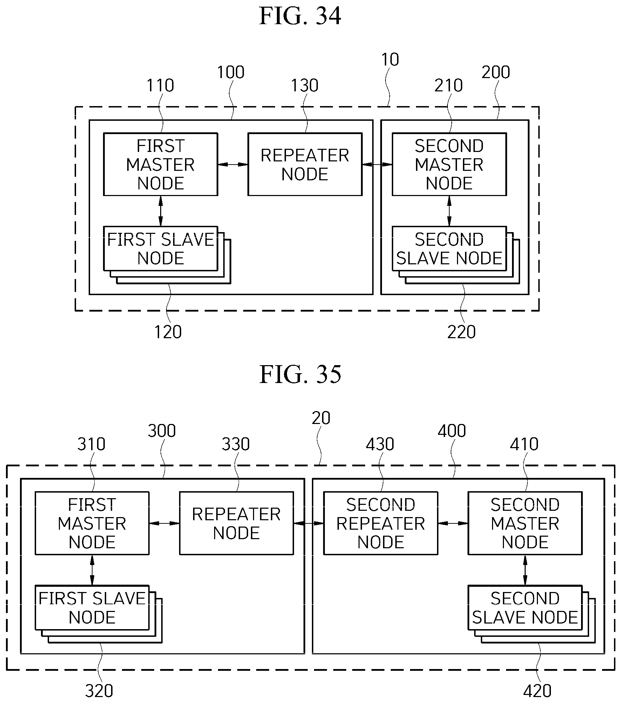

FIG. 34 is a block diagram illustrating a configuration of a network system according to a first embodiment of the present invention.

A network system 10 according to a first embodiment of the present invention includes a main wired network device 100 and a sub wired network device 200. A plurality of sub wired network devices 200 may be included in the network system 10.

The main wired network device 100 or the sub wired network device 200 may include a conductive fabric area network. It goes without saying that both the main wired network device 100 and the sub wired network device 200 may include the conductive fabric area network.

The main wired network device 100 and the sub wired network device 200 may communicate with each other using at least one of wired communication and wireless communication.

The main wired network device 100 and the sub wired network device 200 may each be included in a different wearable device. For example, the main wired network device 100 may be included in an upper garment, and the sub wired network device 200 may be included in a lower garment. In this specification, "wearable device" refers to any device that may be carried using a user's body or clothing, including not only devices that may be worn in the form of clothing but also a smartwatch, smart glasses, a head-mounted display (HMD), a touchscreen, an eye tracker, a device for recognizing a user's posture or movement, an auxiliary battery, or the like.

Although not illustrated in the drawings, the main wired network device 100 may further include a power supply device. The main wired network device 100 may wirelessly transmit power to the sub wired network device 200.

Although not illustrated in the drawings, the sub wired network device 200 may further include a capacitor having a conductive fiber layer as an electrode. The sub wired network device 200 may charge the capacitor using power received from the main wired network device 100. Additionally, the sub wired network device 200 may transmit data collected from the outside or generated by itself to the main wired network device 100 using the power charged in the capacitor.

The capacitor included in the sub wired network device 200 may be formed to include two separated conductive fiber layers as electrodes and a dielectric layer interposed between the two conductive fiber layers.

The main wired network device 100 includes a first master node 110, a first slave node 120, and a repeater node 130. A plurality of first slave nodes 120 or repeater nodes 130 may be provided.

The sub wired network device 200 includes a second master node 210 and a second slave node 220. A plurality of second slave nodes 220 may be provided.

When the main wired network device 100 includes a conductive fiber-based network, the first master node 110 transmits and receives data to and from the first slave node 120 and the repeater node 130 through the conductive fiber layer. The first slave node 120 may be a sensor capable of recognizing a user's biosignal, posture, or movement, and collects sensor data and transmits the collected sensor data to the first master node 110 through the conductive fiber layer.

When the sub wired network device 200 includes the conductive fiber-based network, the second master node 210 transmits and receives data to and from the second slave node 220 through the conductive fiber layer. The second slave node 220 may be a sensor capable of recognizing a user's biosignal, posture, or movement, and collects sensor data and transmits the collected sensor data to the second master node 210 through the conductive fiber layer.

The repeater node 130 wirelessly transmits power to the second master node 210 and wirelessly transmits and receives data to and from the second master node 210. There are no restrictions on the wireless communication methods that the main wired network device 100 and the sub wired network device 200 may use. For example, the wireless communication method may be any one of Bluetooth, Bluetooth low energy (BLE), near field communication (NFC), radio frequency identification (RFID), Wi-Fi, beacon, ZigBee communication, and ultra wide band (UWB) communication, or a combination thereof. Meanwhile, there are no restrictions on the method by which the main wired network device 100 wirelessly transmits power to the sub wired network device 200. For example, the main wired network device 100 may wirelessly transmit power to the sub wired network device 200 using a magnetic induction method or a magnetic resonance method.

When the second slave node 220 transmits sensor data to the second master node 210, the second master node 210 may wirelessly transmit the sensor data to the repeater node 130. While the second master node 210 is transmitting data to the repeater node 130, the repeater node 130 may stop an operation of supplying power to the second master node 210 to prevent interference from occurring during the data transmission process.

The data transmitted and received between the repeater node 130 and the second master node 210 may include an identifier of the main wired network device 100, an identifier of the sub wired network device 200, an identifier of a node that transmits data (a node ID that serves as a source address), and an identifier of a node that receives data (a node ID that serves as a destination address). For example, the node ID that serves as the source address may be an identifier of a sensor 220 included in the sub wired network device 200, and the node ID that serves as the destination address may be an identifier of a storage device 120 included in the main wired network device 100.

When the main wired network device 100 includes a power supply device, the first master node 110 may transmit power supplied from the power supply device to the repeater node 130 through the conductive fiber layer. The repeater node 130 may wirelessly transmit power to the second master node 210.

Although not illustrated in the drawings, the sub wired network device 200 may include a capacitor having the conductive fiber layer as an electrode. In this case, the second master node 210 may charge the capacitor with the power received from the repeater node 130. Additionally, the second master node 210 may transmit data collected or generated by the sub wired network device 200 to the repeater node 130 using the power charged in the capacitor.

The capacitor included in the sub wired network device 200 may be formed to include two separated conductive fiber layers as electrodes and a dielectric layer interposed between the two conductive fiber layers.

Even though some content has been omitted during the process of describing the embodiment of FIG. 34, the content of FIGS. 1 to 33 may be applied to the content of FIG. 34. Furthermore, the content of FIG. 34 may be applied to the content of FIGS. 1 to 33.

### Example of method of forming connection between network system of conductive fabric area and network device of conductive fabric area

Hereafter, an example of a method for forming a connection between a network system and a network device according to the present invention will be described.

A network system according to an embodiment of the present invention includes a main wired network device and a sub wired network device. The main wired network device and the sub wired network device communicate with each other using at least one of wired communication and wireless communication.

In an embodiment of the present invention, the main wired network device and the sub wired network device may each be included in a different wearable device.

In an embodiment of the present invention, the main wired network device may further include a power supply device. In this case, the main wired network device may wirelessly transmit power to the sub wired network device.

In an embodiment of the present invention, the sub wired network device may further include a capacitor having a conductive fiber layer as an electrode. In this case, the sub wired network device charges the capacitor with power received from the main wired network device and may transmit data to the main wired network device using the power charged in the capacitor.

In an embodiment of the present invention, the capacitor may include two separated conductive fiber layers as electrodes and a dielectric layer interposed between the two conductive fiber layers.

In an embodiment of the present invention, the main wired network device includes a first master node and a repeater node, and the sub wired network device includes a second master node. The first master node transmits and receives data to and from the repeater node through the conductive fiber layer, and the repeater node wirelessly transmits and receives data to and from the second master node.

In an embodiment of the present invention, the sub wired network device may further include a slave node that collects sensor data. In this case, the slave node transmits the sensor data to the second master node, and the second master node wirelessly transmits the sensor data to the repeater node.

In an embodiment of the present invention, the data transmitted and received between the repeater node and the second master node may include an identifier of the main wired network device; an identifier of the sub wired network device; an identifier of a node that transmits data; and an identifier of a node that receives data.

In an embodiment of the present invention, the main wired network device may further include a power supply device. In this case, the first master node transmits power supplied from the power supply device to the repeater node through the conductive fiber layer, and the repeater node may wirelessly transmit power to the second master node.

In an embodiment of the present invention, the main wired network device may further include a power supply device. The sub wired network device may further include the capacitor having the conductive fiber layer as the electrode. In this case, the first master node transmits power supplied from the power supply device to the repeater node through the conductive fiber layer, and the second master node charges the capacitor with the power received from the repeater node, and may transmit data generated by the sub wired network device to the repeater node using the power charged in the capacitor.

In an embodiment of the present invention, the capacitor may include two separated conductive fiber layers as electrodes and a dielectric layer interposed between the two conductive fiber layers.

In an embodiment of the present invention, the repeater node may stop the operation of transmitting power to the second master node when the second master node transmits data to the repeater node.

In an embodiment of the present invention, any one or both of the main wired network device or the sub wired network device may be a device including the conductive fabric area network.

A method of forming a connection between wired network devices according to an embodiment of the present invention includes transmitting, by the main wired network device, a wireless connection request message to the sub wired network device; transmitting, by the sub wired network device, an association response message to the main wired network device; and transmitting, by the main wired network device, a connection acknowledgment message to the sub wired network device.

In an embodiment of the present invention, the connection acknowledgment message may include an identifier of the main wired network device and a network identifier assigned by the main wired network device to the sub wired network device.

In an embodiment of the present invention, the transmitting of the connection request message may include: transmitting, by a first master node included in the main wired network device, the connection request message to a second master node of the sub wired network device through a repeater node of the main wired network device; and transmitting, by the second master node, the connection request message to a slave node of the sub wired network device.

In an embodiment of the present invention, the transmitting of the association response message may include: transmitting, by the slave node, the association response message to the second master node; transmitting, by the second master node, the association response message to the repeater node; and transmitting, by the repeater node, the association response message to the first master node.

In an embodiment of the present invention, the transmitting of the connection acknowledgement message may include: transmitting, by the first master node, the connection acknowledgement message to the second master node through the repeater node; and transmitting, by the second master node, the connection acknowledgement message to the slave node. In this case, the connection acknowledgement message may include a node identifier assigned by the first master node to the slave node.

Furthermore, the conductive fabric area network system according to an embodiment of the present invention includes one main conductive fabric area network device having a plurality of nodes and one or more sub-conductive fabric area network devices having a plurality of nodes. The network devices are each included in a different clothing or body attachment and communicate with each other using at least one of the wired communication and wireless communication means.

### Modified example of method of forming connection between network system of conductive fabric area and network device of conductive fabric area

### [1] Switching of main network

The conductive fabric area network system according to an embodiment of the present invention may be composed of a plurality of conductive fabric area network devices.

For example, the plurality of conductive fabric area network devices may be included in a single body attachment, such as clothing or a wearable suit. As another example, in addition to an upper garment and a lower garment worn by a user, socks, gloves, scarves, and hats may each form a new conductive fabric area network.

In the conductive fabric area network system according to an embodiment of the present invention, when composed of the plurality of conductive fabric area network devices, each network device corresponds to a main wired network device or a sub wired network device. Through message exchange between network devices, the main wired network device may be switched to the sub wired network device, or the sub wired network device may be switched to the main wired network device. For reference, in this modified embodiment, the main wired network device is assumed to be a device that wirelessly provides power to the sub wired network device.

That is, according to an embodiment of the present invention, the conductive fabric area network system includes a first wired network device equipped with a battery and a second wired network device equipped with a battery, in which the first wired network device and the second wired network device communicate with each other using at least one of wired communication and wireless communication, the first wired network device and the second wired network device include a power supply device, the first wired network device and the second wired network device determine one of the two devices to be the main wired network device and the other of the two devices to be the sub wired network device through mutual message exchange, and the main wired network device wirelessly transmits power to the sub wired network device.

Assuming that each conductive fabric area network device is equipped with a battery, it may be determined whether each conductive fabric area network device serves as the main wired network device based on a state of charge or an operating state of the battery. For example, even when the wired network device is equipped with a battery, when the battery is not in operation, the corresponding wired network device may be configured as the sub wired network device. Furthermore, when the battery installed in the sub wired network device is fully charged, the corresponding sub wired network device may be configured as the main wired network device. Additionally, when a battery is installed in the sub wired network device that previously did not have a battery, that sub wired network device may be configured as the main wired network device.

Furthermore, as another embodiment, it is possible to newly add a mobile device to the conductive fabric area network system according to an embodiment of the present invention. For example, a smartphone may become a new wired network device of the network system, form a connection with an existing wired network device, and serve as a new main wired network device. In this case, the smartphone may serve as the main controller of the conductive fabric area network system, such as for biosignal monitoring or network control.

Meanwhile, in relation to the switching of roles between a main wired network and a sub wired network, there may be required a protocol (assignment of an identifier designating the main wired network) for changing a status between networks under the control of an existing main wired network in response to the occurrence of an event caused by a change in a battery connection state, a remaining battery level, or the like, and a data format (status value) included in a message used for the status change.

### [2] Function switching of node

In relation to [1], the conductive fabric area network device included in the conductive fabric area network system according to an embodiment of the present invention may include a node capable of acting as both a master node and a repeater node.

For example, assuming a situation in which the two wired network devices are included in the conductive fabric area network system, when the existing main wired network device (first device) is switched to the sub wired network device and the existing sub wired network device (second device) is switched to the main wired network device, the repeater node of the first device should be able to receive power from the master node of the second device, and the master node of the second device should be able to transmit power to the repeater node of the first device. Therefore, the node responsible for the connection between the first device and the second device should be a node capable of performing the roles of both the repeater node and the master node. That is, the node capable of performing the roles of both the repeater node and the master node is a node capable of performing the roles of both the transmitting and receiving ends of the wireless power transmission.

### [3] Interconnection between power transmission and data transmission

In the conductive fabric area network system according to an embodiment of the present invention, power transmission and data transmission are performed between the repeater node of the main wired network and the master node of the sub wired network. In this case, the master node of the main wired network performs scheduling to prevent the power transmission and data transmission from being performed simultaneously, and through communication with a sub wired network, causes the data transmission to be suspended while power is being transmitted, or transmits a message to the repeater node of the main wired network such that the repeater node of the main wired network suspends the power transmission to the master node of the sub wired network while the sub wired network performs the data transmission. The master node of the main wired network may determine the priority of the power transmission and data transmission. For example, the criteria for determining the priority may include the state of charge of the battery installed in the sub wired network, the state of charge of the battery installed in the main wired network, or the importance of the data to be transmitted, etc. When a specific biosignal exceeds a threshold value, the importance of the corresponding biosignal data may increase.

### [4] Example in which plurality of main wired networks exist

In relation to [1], the plurality of main wired networks and the plurality of sub wired networks may exist in the conductive fabric area network system according to an embodiment of the present invention. In this case, each main wired network separately manages the network area it is responsible for. Each main wired network determines the sub wired network it is responsible for through mutual message exchange. For example, among the main wired networks, the sub wired network to be assigned may be determined based on an exchange of messages regarding a battery connection status and the state of charge of the battery of each wired network and application of predefined rules. This modified embodiment operates in such a way that the plurality of main wired network devices coexist in a single conductive fabric area network system, and each main wired network device transmits power only to the sub wired network corresponding to its assigned area.

FIG. 35 is a block diagram illustrating a configuration of a network system according to a second embodiment of the present invention. The network system according to the second embodiment differs from the first embodiment in that a main wired network device and a sub wired network device are not predetermined, and a main wired network device is determined through communication between wired network devices. This characteristic may allow for flexible power balance between wired network devices included in the network system by changing a power supply source according to a state of charge of each wired network device.

A network system 20 according to the second embodiment of the present invention includes a main wired network device 300 and a second wired network device 400. A plurality of sub wired network devices 200 may be included in the network system 20. For example, three or more sub wired network devices may be included in the network system 20.

The first wired network device 300 and/or the second wired network device 400 may include a conductive fabric area network (CFAN). Accordingly, in addition to the connection method of the CFAN described above (FIG. 6) and the connection method of the extended CFAN (FIG. 7), all the connection methods and connection formation methods between the network system of the conductive fabric area and the network device of the conductive fabric area described in this specification may be applied to the network system 20. That is, the first wired network device 300 and the second wired network device 400 may be the conductive fabric area network device.

The first wired network device 300 and the second wired network device 400 may communicate with each other using at least one of wired communication and wireless communication.

The first wired network device 300 and the second wired network device 400 may each be included in a different wearable device. For example, the first wired network device 300 may be included in an upper garment, and the second wired network device 400 may be included in a lower garment. In this specification, "wearable device" refers to any device that may be carried using a user's body or clothing, including not only devices that may be worn in the form of clothing but also a smartwatch, smart glasses, a head-mounted display (HMD), a touchscreen, an eye tracker, a device for recognizing a user's posture or movement, an auxiliary battery, or the like.

Although not illustrated in the drawings, the first wired network device 300 and/or the second wired network device 400 may further include a power supply device. The first wired network device 300 and the second wired network device 400 may wirelessly transmit power in both directions. That is, either the first wired network device 300 or the second wired network device 400 may serve as a power supply source.

Although not illustrated in the drawings, the first wired network device 300 and/or the second wired network device 400 may further include a capacitor having the conductive fiber layer as an electrode. The first wired network device 300 and/or the second wired network device 400 may charge the capacitor with received power. The capacitor may be formed to include two separated conductive fiber layers as electrodes and a dielectric layer interposed between the two conductive fiber layers.

Furthermore, either the first wired network device 300 or the second wired network device 400 may transmit data collected from the outside or generated by itself to the other wired network device using the power charged in the capacitor.

As illustrated in FIG. 35, the first wired network device 300 includes a first master node 310, a first slave node 320, and a first repeater node 330. A plurality of first slave nodes 320 and/or first repeater nodes 330 may be provided. Additionally, the second wired network device 400 includes a second master node 410, a second slave node 420, and a second repeater node 430. A plurality of second slave nodes 420 and/or second repeater nodes 430 may be provided. The nodes 310, 320, 330, 410, 420, and 430 included in the network system 20 may include an impedance matching circuit, a battery, a processor, and a memory. For example, the nodes included in the network system 20 may be smartphones or IoT devices. Additionally, the repeater nodes 330 and 430 included in the network system 20 may further include a wireless communication device (Wi-Fi, ZigBee, RF, etc.), an antenna, a coil, or a rectifier circuit.

When the wired network devices 300 and 400 included in a network system 20 include the conductive fiber-based network, the master nodes 310 and 410 transmit and receive data to and from the slave nodes 320 and 420 and the repeater nodes 330 and 430 through the conductive fiber layer. The slave nodes 320 and 420 may be sensors capable of recognizing a user's biosignal, posture, or movement, and collect sensor data and transmit the collected sensor data to the master nodes 310 and 410 through the conductive fiber layer.

The repeater nodes 330 and 430 may wirelessly transmit power to each other or transmit and receive data using a wireless communication method. Additionally, the repeater nodes 330 and 430 may transmit and receive data to and from the master nodes 310 and 410. There are no restrictions on the wireless communication methods that the first wired network device 300 and the second wired network device 400 may use. For example, the wireless communication method may be any one of Bluetooth, Bluetooth low energy (BLE), near field communication (NFC), radio frequency identification (RFID), Wi-Fi, beacon, ZigBee communication, and ultra wide band (UWB) communication, or a combination thereof. Meanwhile, the present invention does not impose any restrictions on the method of wirelessly transmitting power between the wired network devices 300 and 400. For example, the first wired network device 300 may wirelessly transmit power to the second wired network device 400 using a magnetic induction method or a magnetic resonance method, and vice versa.

Meanwhile, when the data transmission starts between the first wired network device 300 and the second wired network device 400 while power is being transmitted between the first wired network device 300 and the second wired network device 400, the power transmission may be suspended during the data transmission time. For example, when the power is being transmitted from the first repeater node 330 to the second repeater node 430, and the data transmission starts between the first wired network device 300 and the second wired network device 400, the second slave node 420 transmits sensor data to the second master node 410, and the second master node 410 may wirelessly transmit sensor data to the first repeater node 330 through the second repeater node 430. Before the second repeater node 430 transmits the sensor data to the first repeater node 330, or while the second repeater node 430 transmits the sensor data to the first repeater node 330, the first repeater node 330 may stop the operation of transmitting power to the second repeater node 430 either on its own or under the control of the first master node 310 in order to prevent interference during the data transmission process.

The data transmitted and received between the repeater nodes 330 and 430 may include an identifier of the wired network devices 300 and 400, an identifier of a node that transmits the data (a node ID that serves as the source address), and an identifier of a node that receives the data (a node ID that serves as the destination address). For example, a node ID that serves as the source address may be an identifier of a sensor that is one of the second slave nodes 420 included in the second wired network device 400, and a node ID that serves as the destination address may be an identifier of a data storage device that is one of the first slave nodes 320 included in the first wired network device 300.

When the wired network devices 300 and 400 include a separate power supply device or are connected thereto, the master nodes 310 and 410 may transmit power supplied from the power supply device to the slave nodes 320 and 420 or the repeater nodes 330 and 430 through the conductive fiber layer. Additionally, each of the repeater nodes 330 and 430 may wirelessly transmit power to the other repeater node 430 and 330.

Although not illustrated in the drawings, the wired network devices 300 and 400 may include the capacitor having the conductive fiber layer as the electrode. In this case, the master nodes 310 and 410 may charge the capacitor with power received from the repeater nodes 330 and 430. Furthermore, the master nodes 310 and 410 may use the power charged in the capacitor to transmit data collected or generated by the wired network devices 300 and 400 to the other repeater nodes 430 and 330 through the repeater nodes 330 and 430. The capacitor described above may be formed to include two separated conductive fiber layers as electrodes and a dielectric layer interposed between the two conductive fiber layers.

In the network system according to the second embodiment of the present invention, the main network device is determined among the plurality of wired network devices. The main network device may be determined automatically or manually. The user may determine the main network device manually according to the user's intention or determine criteria (which may also be referred to as "criterion information") for determining the main network used when the main network device is determined automatically. The criteria (or criterion information) may be the state of charge, startup time, or data transmitting entity, etc.

In this specification, the criterion information corresponding to a specific wired network device is referred to as "operation information."

One of the first wired network device 300 and the second wired network device 400 may be determined as the main network device and the other of the first wired network device 300 and the second wired network device 400 may be determined as the sub network device, based on the reference information of the main network device.

For example, the first master node 310 requests reference information for determining the main network from the second master node 410 through the first repeater node 330 and the second repeater node 430. The reference information may be the state of charge of the battery installed in the second wired network device 400 or the startup time of the second wired network device 400. The second master node 410 transmits the reference information for determining the main network to the first master node 310 through the second repeater node 430 and the first repeater node 330. When the first master node 310 receives the reference information for determining the main network from the second master node 410, the first master node 310 determines one of the first wired network device 300 and the second wired network device 400 to be the main network device and the other of the first wired network device 300 and the second wired network device 400 to be the sub network device based on the reference information. When the reference information is the state of charge of the battery, the first master node 310 determines the second wired network device 400 to be the main network device and the first wired network device 300 to be the sub network device when the state of charge of the battery installed in the second wired network device 400 is greater than the state of charge of the battery installed in the first wired network device 300. In addition, as another example, when the reference information is the startup time, the first master node 310 determines the first wired network device 300 to be the main network device when the startup time of the first wired network device 300 is earlier than the startup time of the second wired network device 400.

As another example, the reference information for determining the main network device used when the main network device is automatically determined may be the data receiving entity. In this case, the wired network device that becomes the data transmitting entity may be the sub network device, and the wired network device (the wired network device that transmits the data transmission request message) that becomes the data receiving entity may be the main network device. For example, when the first wired network device 300 is the data transmitting entity and the state of charge of the second wired network device 400 is greater than or equal to the set minimum state of charge, the first wired network device 300 becomes the sub network device, and the second wired network device 400 to receive the data becomes the main network device. In this case, the second wired network device 400 transmits power required for data transmission to the first wired network device 300, and the first wired network device 300 uses the received power to transmit power to the second wired network device 400.

Meanwhile, the first wired network device 300 and the second wired network device 400 may perform impedance matching between internal nodes when a power supply is turned on, when a new device is added to the network, or at regular intervals. For example, in the conductive fabric area network where a plurality of nodes are connected to each other, problems with signal integrity and power efficiency may arise as node density increases. Since the impedance mismatch between nodes significantly degrades the performance of wired network devices and increases power consumption, optimal impedance matching for a multi-node conductive fabric area network is necessary. For example, in the wired network device in which each node is connected via the conductive fabric area network, the interaction between the conductive fiber and the node affects the network impedance, and the newly added node may change the overall impedance, thereby affecting signal integrity. Therefore, proper impedance matching is essential to minimize signal reflections and ensure network stability as the node density increases. The master nodes 310 and 410 may perform the impedance matching with one or more slave nodes 320 and 420 or repeater nodes 330 and 430 by applying a specific impedance matching technique.

The impedance matching technique may be any one of complex conjugate matching, equal impedance matching, and voltage maximization matching. Among these, the complex conjugate matching is effective in minimizing reflections by creating a balanced network that facilitates energy flow; however, when a large number of nodes are introduced into the network of the wired network devices, it has a disadvantage in that it requires recalibration that changes the overall network impedance, thereby complicating the impedance matching process. Therefore, the complex conjugate matching may not be a practical choice from the perspective of expanding the wired network device. Additionally, the same impedance matching is a method of standardizing impedance at all nodes in a network. Although an optimal power transmission rate may not be achieved, it is a suitable method for ensuring network stability and reliability in environments where node density frequently changes. Furthermore, the voltage maximization matching is an impedance matching technique that aims to optimize voltage delivery to the receiver by fine-tuning the resistances of the transmitter and receiver, and the voltage at the receiver may be expressed as Equation 3. [Equation 3] ${V}_{R} = \frac{{V}_{T} {R}_{R}}{{R}_{T} + {NR}_{R}}$

In Equation 3, V_{R} denotes the voltage of the receiver, V_{T} denotes the input voltage of the transmitter, R_{R} denotes the resistance of the receiver, R_{T} denotes the resistance of the transmitter, and N denotes the number of nodes of the receiver. For example, the master nodes 310 and 410 may set themselves as the transmitting end of Equation 3 and set one or more nodes as the receiving ends of Equation 3 to perform the impedance matching through the voltage maximization matching. The master nodes 310 and 410 may perform the impedance matching while gradually lowering transmitting end resistance R_{T}. This approach is effective for supporting high-density conductive fabric area networks with many nodes by increasing voltage transmission efficiency.

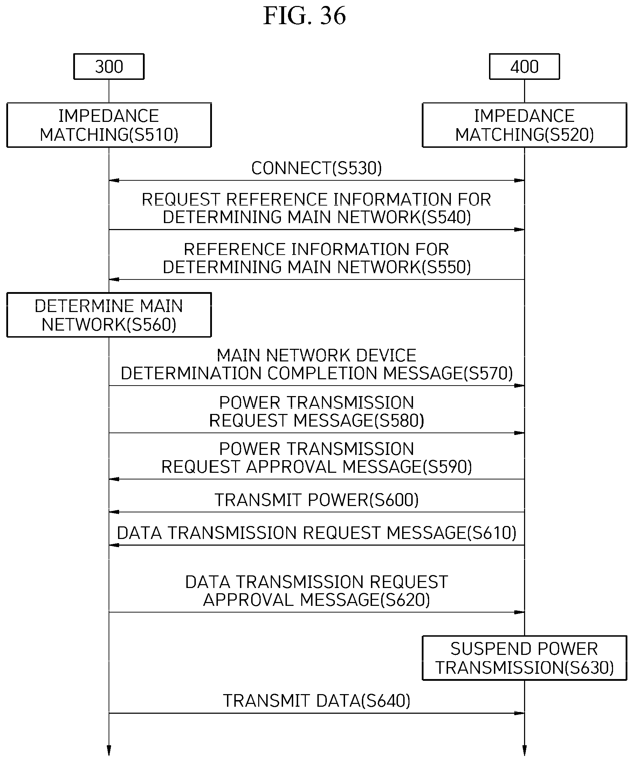

FIG. 36 is a flowchart for describing a method of operating the network system according to the second embodiment of the present invention. The operation method may be performed by the network system 20. As illustrated in FIG. 35, the network system 20 includes the first wired network device 300 and the second wired network device 400.

Referring to FIG. 36, in an embodiment of the present invention, the method of operating a network system is composed of operations S510 to S640. The method of operating a network system illustrated in FIG. 36 is according to an embodiment, and the operations of the method of operating a network system according to the present invention are not limited to the embodiment illustrated in FIG. 36, and some operations may be added, changed, or deleted as necessary.

Operations S510 and S520 are impedance matching operations.

When the power supply of the first wired network device 300 and the second wired network device 400 is turned on, the first wired network device 300 and the second wired network device 400 confirm the nodes connected to the internal network of each device and perform impedance matching when a node is added.

For example, the first master node 310 confirms whether a new first slave node 320 has been added to the network of the first wired network device 300. When a new first slave node 320 is added to the network inside the first wired network device 300, the first master node 310 adjusts the impedance between the first master node 310 and all first slave nodes 320 in real time by applying a predetermined impedance matching technique.

The impedance matching technique performed by the first master node 310 or the second master node 410 may be any one of the complex conjugate matching, the equal impedance matching, and the voltage maximization matching.

Operation S530 is a connection operation.

The first master node 310 or the first slave node 320 may form a connection with the second master node 410 or the second slave node 420 via the first repeater node 330 and the second repeater node 430. Conversely, the second master node 410 or the second slave node 420 may form the connection with the first master node 310 or the first slave node 320 via the second repeater node 430 and the first repeater node 330. This connection formation process may be performed according to the connection method of the extended CFAN of FIG. 7.

For example, the second master node 410 transmits a connection request packet to the first master node 310 through the second repeater node 430 and the first repeater node 330, and the first master node 310 transmits the connection request packet to the first slave node 320. The first slave node 320 transmits an association response packet to the first master node 310, and the first master node 310 may transmit the association response packet to the second master node 410 through the first repeater node 330 and the second repeater node 430.

The determination of the main network device may be performed automatically or manually depending on the settings. When the determination of the main network device is performed manually, the next operations S540 to S570 are omitted.

When the determination of the main network device is set to be performed automatically, the first master node 310 and the second master node 410 may determine the master node that will determine the main network device during this process. For example, the first master node 310 and the second master node 410 may determine the master node with the earlier startup time to be the master node that will determine the main network device, based on an operation (on) time. As another example, the first master node 310 and the second master node 410 may each randomly generate a number greater than or equal to 0 and less than 1 and may determine the master node that generates the larger number to be a master node for determining the main network device.

In the present embodiment, it is assumed that the first master node 310 has been determined as the master node that will determine the main network device.

Operation S540 is an operation of requesting reference information for determining the main network.

The first master node 310 requests reference information for determining the main network from the second master node 410 through the first repeater node 330 and the second repeater node 430.

The reference information may be the state of charge of the battery installed in the second wired network device 400, the startup time of the second wired network device 400, or whether the second wired network device 400 is the data transmitting entity (whether the second wired network device is the data transmitting entity). When the criterion for determining the main network is the "data receiving entity," the data transmission is given a higher priority than power transmission. In this case, the wired network device that is the data receiving entity transmits the power required by the wired network device that is the data transmitting entity (e.g., power sufficient to transmit data without interruption).

Operation S550 is an operation of transmitting reference information for determining the main network.

The second master node 410 transmits the reference information for determining the main network to the first master node 310 through the second repeater node 430 and the first repeater node 330.

Operation S560 is the main network determination operation.

When the first master node 310 receives the reference information for determining the main network from the second master node 410, the first master node 310 determines one of the first wired network device 300 and the second wired network device 400 to be the main network device and the other of the first wired network device 300 and the second wired network device 400 to be the sub network device based on the reference information. For example, the first master node 310 may determine the second wired network device 400 to be the main network device and the first wired network device 300 to be the sub network device when the state of charge of the battery installed in the second wired network device 400 is greater than the state of charge of the battery installed in the first wired network device 300. As another example, the first master node 310 may determine the first wired network device 300 to be the main network device when the startup time of the first wired network device 300 is earlier than the startup time of the second wired network device 400.

The present embodiment describes the subsequent operations under the assumption that the second wired network device 400 is determined as the main network device and the first wired network device 300 is determined as the sub network device.

Operation S570 is an operation of transmitting a main network device determination completion message.

The first master node 310 transmits the main network determination completion message to the second master node 410 through the first repeater node 330 and the second repeater node 430. The message includes the result of the determination that the second wired network device 400 has been determined as the main network device.

Operation S580 is an operation of transmitting a power transmission request message.

The first master node 310 may confirm the state of charge of the battery installed in the first wired network device 300, and when the state of charge is below a predetermined threshold, may transmit a power transmission request message to the second master node 410 through the first repeater node 330 and the second repeater node 430.

Operation S590 is the operation of transmitting a power transmission request approval message.

The second master node 410 checks the state of charge of the battery installed in the second wired network device 400, and when the state of charge is greater than or equal to a predetermined threshold, may transmit the power transmission request approval message to the first master node 310 through the second repeater node 430 and the first repeater node 410. The approval message is a response message to the power transmission request message of operation S580.

Operation S600 is a power transmission operation.

The second repeater node 430 wirelessly transmits power to the first repeater node 330. The first repeater node 330, having received power from the second repeater node 430, transmits power to the first master node 310 or the first slave node 320 under the control of the first master node 310.

Operation S610 is an operation of transmitting a data transmission request message.

In the present embodiment, a situation is assumed in which the second slave node 420 requests data transmission from the first slave node 320.

The second slave node 420 transmits the conditions (e.g., type and duration of data - which may be a query) for the data to be requested from the first slave node 320 to the second master node 410, and the second master node 410 generates the data transmission request message based on the above conditions. The second master node 410 transmits the data transmission request message to the first master node 310 through the second repeater node 430 and the first repeater node 330.

Operation S620 is an operation of transmitting the data transmission request approval message.

The first master node 310 determines whether to approve the data transmission request message through communication with the first slave node 320. For example, the data transmission request message may be a request for a brainwave signal for a specific time interval, and the first master node 310 may determine whether to approve the request by confirming, through communication with the first slave node 320, which is a device that stores the brainwave signal, whether the brainwave signal for the time interval may be provided. For example, the first master node 310 may parse the data transmission request message to extract conditions of requested data, and based on the extracted conditions, query the first slave node 320 as to whether the requested data may be provided, and determine whether to approve the request based on a response to the query.

When the first master node 310 determines that it approves the data transmission request message, the first master node 310 transmits the data transmission request approval message to the second master node 410 through the first repeater node 330 and the second repeater node 430. That is, the data transmission request approval message is a response message to the data transmission request message.

According to a further embodiment of the present invention, the first master node 310 calculates, in response to the data transmission request message, an amount of data (or a data transmission time) to be transmitted from the first repeater node 330 to the second repeater node 430, and determines an amount of power required for data transmission ("required power") based on the amount of data (or the data transmission time) and a predetermined reference table (e.g., a datasheet provided by a chipset manufacturer of a device corresponding to the repeater node). When the required power C_{b} is greater than or equal to the state of charge of the battery Cₐ installed in the first wired network device 300, the first master node 310 calculates the required power (C_{c} = C_{b} - Cₐ + α) and generates the power transmission request message including the required power. Here, α is a set value. The first master node 310 transmits the power transmission request message including the required power amount to the second master node 410 through the first repeater node 330 and the second repeater node 430. Subsequently, operations S580 to S600 are performed, and the first master node 310 confirms whether the power transmission equal to the required power amount has been achieved. When the power transmission equal to the required power amount has been achieved, operations S630 and S640 are performed.

Meanwhile, depending on the data transmission amount, the data transmission time interval and the power transmission time interval may be divided into multiple intervals. For example, when the data transmission amount is a capacity greater than or equal to a predetermined threshold (e.g., 100 MB), the data transmission amount may be transmitted through multiple power transmission time intervals and multiple data transmission time intervals. The number of time intervals may be determined by the master node of the main network device. For example, when the number of time intervals is 2, the power transmission time interval and the data transmission time interval are repeated twice each (power transmission-data transmission-power transmission-data transmission).

Operation S630 is an operation of suspending power transmission.

The second master node 410, which is the master node of the second wired network device 400 which is the main network device, determines whether the data transmission is performed between the second repeater node 430 and the first repeater node 330. When the data transmission is performed between the second repeater node 430 and the first repeater node 330, the second master node 410 controls the second repeater node 430 so as not to transmit power to the first repeater node 330.

For example, when the second master node 410 receives the data transmission request acknowledgment message transmitted by the first wired network device 300 from the second repeater node 430, the second master node 410 determines that the data transmission is performed between the second repeater node 430 and the first repeater node 330, and in order to avoid interference, may control the second repeater node 430 so as not to transmit power to the first repeater node 330 until the data transmission is completed.

Operation S640 is a data transmission operation.

When the first master node 310 confirms that power is not being received by the first repeater node 330, the first master node 310 collects data from the first slave node 320 and transmits the collected data to the second master node 410 through the first repeater node 330 and the second repeater node 430. The second master node 410 transmits the received data to the second slave node 420.

Even though some details have been omitted during the description of the embodiments of FIGS. 35 and 36, the content of FIGS. 1 to 34 and 37 may be applied to FIGS. 35 and 36. In addition, the content of FIGS. 35 and 36 may be applied to the content of FIGS. 1 to 34 and 37.

The above-described method of operating a network system has been described with reference to the flowchart illustrated in FIG. 36. For simplicity, the method has been illustrated and described as a series of blocks, but the invention is not limited to the order of the blocks, and some blocks may occur with other blocks in a different order or at the same time as illustrated and described in the present specification. Also, various other branches, flow paths, and orders of blocks that achieve the same or a similar result may be implemented. In addition, not all the illustrated blocks may be required for implementation of the methods described in the present specification. In the description with reference to FIG. 36, each operation may be further divided into additional operations or combined into fewer operations according to an implementation example of the present invention.

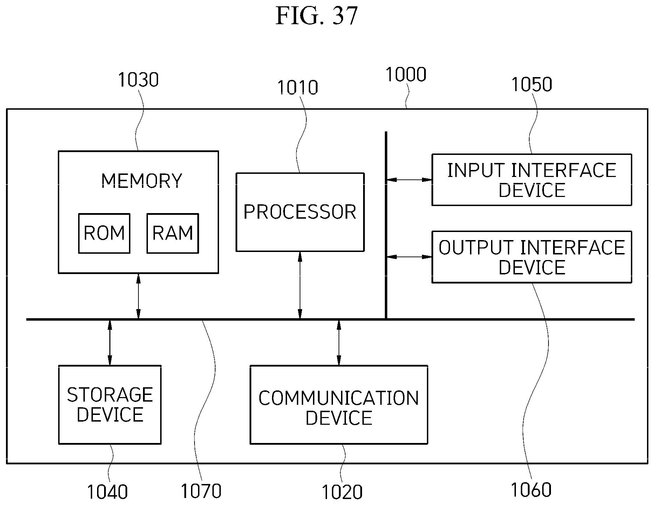

FIG. 37 is a block diagram illustrating a computer system for implementing the method according to the embodiment of the present invention. A network device or a node included in the network device according to an embodiment of the present invention may include the computer system of FIG. 37.

Referring to FIG. 37, a computer system 1000 may include at least one of a processor 1010, a memory 1030, an input interface device 1050, an output interface device 1060, and a storage device 1040 that communicate through a bus 1070. The computer system 1000 may further include a communication device 1020 coupled to a network.

The processor 1010 may be a central processing unit (CPU) or a semiconductor device that executes computer-readable instructions stored in the memory 1030 and/or the storage device 1040. The memory 1030 and the storage device 1040 may include various forms of volatile or nonvolatile media. For example, the memory 1030 may include a read only memory (ROM) or a random access memory (RAM). In an embodiment of the present invention, the memory 1030 may be located inside or outside the processor 1010 and may be connected to the processor 1010 through various known means. The memory 1030 may include various forms of volatile or nonvolatile media, for example, may include a ROM or a RAM.

Accordingly, the embodiments of the present invention may be embodied as a method implemented by a computer or a non-transitory computer readable medium in which computer executable instructions are stored. According to an embodiment, when executed by a processor, computer readable instructions may perform a method according to at least one aspect of the present disclosure.

The communication device 1020 may transmit or receive a wired signal or a wireless signal.

The method according to the embodiment of the present invention may be implemented in the form of program instructions executable by various computer devices and may be recorded on computer readable media. The computer readable media may be provided with program instructions, data files, data structures, and the like alone or in combination. The program instructions recorded on the computer readable media may be specially designed and constructed for the purposes of the present invention or may be well known and available to those skilled in the art of computer software. The computer readable storage media include hardware devices configured to store and execute program instructions. For example, the computer readable storage media include magnetic media such as hard disks, floppy disks, and magnetic tape, optical media such as a CD-ROM and a DVD, magnetooptical media such as floptical disks, a ROM, a RAM, a flash memory, etc. The program instructions include not only machine language code made by a compiler but also high level code that may be used by an interpreter etc., which is executed by a computer.

Although exemplary embodiments of the present invention have been disclosed above, it may be understood by those skilled in the art that the present invention may be variously modified and changed without departing from the scope of the present invention as described in the following claims.

## Claims

1. A network system comprising a first wired network device and a second wired network device,
wherein the first wired network device includes a first master node and a first repeater node,
the second wired network device includes a second master node and a second repeater node,
the first repeater node and the second repeater node communicate using a wireless communication method, and
the first master node requests operation information for determining a main network from the second master node through the first repeater node and the second repeater node, and upon receiving the operation information from the second master node, determines one of the first wired network device and the second wired network device to be the main network device and the other of the first wired network device and the second wired network device to be a sub network device based on the operation information.

2. The network system of claim 1, wherein the operation information is a state of charge of a battery installed in the second wired network device, and
the first master node determines the main network device based on a result of comparing the state of charge of the battery installed in the second wired network device with a state of charge of a battery installed in the first wired network device.

3. The network system of claim 1, wherein the operation information is a startup time of the second wired network device, and
the first master node determines the main network device based on a result of comparing the startup time of the second wired network device with a startup time of the first wired network device.

4. The network system of claim 1, wherein the repeater node of the main network device wirelessly transmits power to the repeater node of the sub network device.

5. The network system of claim 4, wherein the repeater node of the sub network device transmits power to a master node of the sub network device under control of the master node of the sub network device.

6. The network system of claim 4, wherein, when data transmission is performed between the repeater node of the main network device and the repeater node of the sub network device, the master node of the main network device controls the repeater node of the main network device so as not to transmit power to the repeater node of the sub network device.

7. The network system of claim 1, wherein the first wired network device further includes one or more first slave nodes, and
when the first slave node is added to a network inside the first wired network device, the first master node applies a predetermined impedance matching technique to adjust an impedance of the first master node and the first slave node in real time.

8. The network system of claim 7, wherein the impedance matching technique is a voltage maximization matching technique.

9. The network system of claim 1, wherein the first wired network device and the second wired network device are conductive fabric area network devices.

10. A method of operating a network system comprising a first wired network device including a first master node and a first repeater node and a second wired network device including a second master node and a second repeater node, the first repeater node and the second repeater node communicating using a wireless communication method, the method comprising:
requesting, by the first master node, operation information for determining a main network from the second master node through the first repeater node and the second repeater node;
receiving, by the first master node, the operation information from the second master node; and
determining, by the first master node, one of the first wired network device and the second wired network device to be a main network device and determining the other of the first wired network device and the second wired network device to be a sub network device based on the operation information.

11. The method of claim 10, wherein the operation information is a state of charge of a battery installed in the second wired network device, and
in the determining of the main network device, the first master node determines the main network device based on a result of comparing the state of charge of the battery installed in the second wired network device with a state of charge of a battery installed in the first wired network device.

12. The method of claim 10, wherein the operation information is a startup time of the second wired network device, and
in the determining of the main network device, the first master node determines the main network device based on a result of comparing a state of charge of a battery installed in the second wired network device with a state of charge of a battery installed in the first wired network device.

13. The method of claim 10, further comprising wirelessly transmitting, by the repeater node of the main network device, power to the repeater node of the sub network device.

14. The method of claim 13, further comprising transmitting, by the repeater node of the sub network device, power to a master node of the sub network device under control of the master node of the sub network device.

15. The method of claim 13, further comprising:
determining, by the master node of the main network device, whether data transmission is performed between the repeater node of the main network device and the repeater node of the sub network device; and
controlling, by the master node of the main network device, the repeater node of the main network device so as not to transmit power to the repeater node of the sub network device when the data transmission is performed between the repeater node of the main network device and the repeater node of the sub network device.

16. The method of claim 10, wherein the first wired network device further includes one or more first slave nodes, and
the method of operating a network system further includes:
confirming, by the first master node, whether the first slave node is added to a network inside the first wired network device; and
applying, by the first master node, a predetermined impedance matching technique to adjust an impedance of the first master node and the first slave node in real time when the first slave node is added to the network inside the first wired network device.

17. The method of claim 16, wherein the impedance matching technique is a voltage maximization matching technique.

18. The method of claim 10, wherein the first wired network device and the second wired network device are conductive fabric area network devices.
